(19) Europäisches Patentamt / European Patent Office / Office européen des brevets

(11) **EP 3 258 298 A1**

(12) **EUROPEAN PATENT APPLICATION**
published in accordance with Art. 153(4) EPC

(43) Date of publication:
**20.12.2017 Bulletin 2017/51**

(51) Int Cl.:
*G02B 5/02* (2006.01)    *B32B 27/00* (2006.01)
*B32B 27/20* (2006.01)    *C09J 7/00* (2006.01)
*C09J 133/00* (2006.01)    *H01L 51/50* (2006.01)
*H05B 33/02* (2006.01)

(21) Application number: **16749130.7**

(22) Date of filing: **03.02.2016**

(86) International application number:
**PCT/JP2016/053251**

(87) International publication number:
**WO 2016/129486 (18.08.2016 Gazette 2016/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **09.02.2015 JP 2015023476**

(71) Applicant: **Zeon Corporation**
**Tokyo 100-8323 (JP)**

(72) Inventors:
• **INOUE, Hiroyasu**
  **Tokyo 100-8246 (JP)**
• **II, Yasunori**
  **Tokyo 100-8246 (JP)**

(74) Representative: **Hansen, Norbert**
**Maiwald Patentanwalts GmbH**
**Elisenhof**
**Elisenstraße 3**
**80335 München (DE)**

(54) **OPTICAL LAYERED BODY AND METHOD FOR MANUFACTURING SAME**

(57)    An optical layered body including a substrate and an adhesive layer formed on the substrate, wherein the adhesive layer includes an acrylic adhesive composition containing an acrylic polymer, and a light scattering particle, the acrylic polymer is a copolymer of a copolymerizing component [I] which contains 40% by weight to 93% by weight of an aromatic ring-containing monomer (a1), and 7% by weight to 60% by weight of a hydroxyl group-containing monomer (a2), the acrylic polymer has a weight-average molecular weight of 200,000 or less, the light scattering particle has a volume concentration V relative to the adhesive layer of 3% to 35%, the acrylic adhesive composition has a refractive index of 1.52 to 1.67, and the light scattering particle has a refractive index of 1.4 to 1.49.

## FIG.1

**Description**

Field

The present invention relates to an optical layered body including a substrate and an adhesive layer, and a method for producing the same.

Background

An organic electroluminescent element which includes a light-emitting layer provided between a plurality of electrode layers to thereby electrically obtain luminescence has excellent characteristics such as high light-emitting efficiency, low voltage drive, low weight, and low cost. Hereinafter, an organic electroluminescent element is sometimes appropriately referred to as an "organic EL element". In order to take advantage of the aforementioned excellent characteristics of the organic EL element, an attempt has been made to develop a light source device to which an organic EL element is applied, such as flat-type illumination devices and backlight devices for liquid crystal display devices.

When an organic EL element is applied to a light source device, an optical film is sometimes required to be provided on a light output surface of the organic EL element. For example, although the light-emitting efficiency of a light-emitting layer itself of the organic EL element is high, some conditions such as a refractive index difference between layers of a light-emitting device may cause an increase in loss of light while light transmits through and exits the aforementioned layers. To address this concern, in order to reduce such loss of light, an optical film having an appropriate concavo-convex structure is sometimes required to be provided on a light output surface of the organic EL element (see Patent Literature 1).

Such an optical film is usually provided to the light output surface of the organic EL element with an appropriate adhesive agent. For example, a desired light source device can be produced by providing an adhesive layer containing an adhesive agent onto one surface of an optical film to prepare an optical layered body, and bonding the surface of this optical layered body on the adhesive layer side to a light output surface of an organic EL element. In such a light source device, light generated in the light-emitting layer of the organic EL element exits through the adhesive layer and the optical film.

Citation List

Patent Literature

Patent Literature 1: International Publication WO 2012/002260

Summary

Technical Problem

As described in the foregoing, the use of the optical film having a concavo-convex structure can suppress the loss of light in a light source device so that light extraction efficiency is improved. However, according to studies by the present inventor, there are restrictions on the shape of the concavo-convex structure for effectively improving light extraction efficiency. When the concavo-convex structure is attempted to be formed within the range of such restrictions, thickness reduction of the optical film may become difficult, and the number of steps for producing the optical film may increase. Also, when an optical film which does not have the concavo-convex structure is required due to design restrictions of a light source device, it was difficult to improve light extraction efficiency with a conventional technique. Under such circumstances, it is required to develop an optical layered body which is capable of realizing a light source device having excellent light extraction efficiency even when the optical film having the concavo-convex structure for improving light extraction efficiency is not necessarily used.

The present invention has been devised in view of the aforementioned problem. An object of the present invention is to provide a novel optical layered body which is capable of realizing a light source device having excellent light extraction efficiency, and a method for producing the optical layered body.

Solution to Problem

The present inventor has intensively conducted research for solving the aforementioned problem. As a result, the present inventor has found that when an adhesive layer including a combination of an acrylic adhesive composition containing a specific acrylic polymer and specific light scattering particles is used, an optical layered body which realizes a light source device having excellent light extraction efficiency can be achieved. Thus, the present invention has been completed.

That is, the present invention is as follows.

(1) An optical layered body comprising a substrate and an adhesive layer formed on the substrate, wherein the adhesive layer includes an acrylic adhesive composition containing an acrylic polymer, and a light scattering particle,

the acrylic polymer is a copolymer of a copolymerizing component [I] which contains 40% by weight to 93% by weight of an aromatic ring-containing monomer (a1), and 7% by weight to 60% by weight of a hydroxyl group-containing monomer (a2),

the acrylic polymer has a weight-average molecular weight of 200,000 or less,

the light scattering particle has a volume concentration V relative to the adhesive layer of 3% to 35%,

the acrylic adhesive composition has a refractive index of 1.52 to 1.67, and

the light scattering particle has a refractive index of 1.4 to 1.49.

(2) The optical layered body according to (1), wherein the light scattering particle is a silicone particle or an acryl particle.

(3) The optical layered body according to (1) or (2), wherein at least 1/4 in volume of the light scattering particle contained in the adhesive layer has a particle diameter of 0.1 $\mu$m to 1 $\mu$m.

(4) The optical layered body according to any one of (1) to (3), wherein

the light scattering particle has an average particle diameter of 0.1 $\mu$m to 1 $\mu$m, and

D1/L1 is 1 to 6, wherein D1 is a thickness of the adhesive layer, and L1 is a mean free path of light scattering.

(5) The optical layered body according to any one of (1) to (4), wherein a surface of the substrate opposite to the adhesive layer has a concavo-convex structure.

(6) The optical layered body according to (5), wherein

the substrate has a single-layer structure, and

0.05 < Ry/D2 < 0.25 is satisfied wherein Ry is a maximum height of the concavo-convex structure, and D2 is a thickness of the substrate.

(7) The optical layered body according to any one of (1) to (6), which is to be disposed on one side of an organic electroluminescence element.

(8) A method for producing an optical layered body including a substrate and an adhesive layer, the method comprising the steps of:

forming, on the substrate, a film of a coating liquid containing an acrylic polymer and a light scattering particle; and

curing the film of the coating liquid to obtain the adhesive layer, wherein

the acrylic polymer is a copolymer of a copolymerizing component [I] which contains 40% by weight to 93% by weight of an aromatic ring-containing monomer (a1), and 7% by weight to 60% by weight of a hydroxyl group-containing monomer (a2),

the acrylic polymer has a weight-average molecular weight of 200,000 or less,

the light scattering particle has a volume concentration V relative to the adhesive layer of 3% to 35%,

the light scattering particle has a refractive index of 1.4 to 1.49, and

an acrylic adhesive composition as a component other than the light scattering particle in the adhesive layer has a refractive index of 1.52 to 1.67.

(9) A method for producing an optical layered body including a substrate and an adhesive layer, the method comprising the steps of:

forming a film of a coating liquid containing an acrylic polymer and a light scattering particle;

curing the film of the coating liquid to obtain the adhesive layer; and

bonding the adhesive layer and the substrate, wherein

the acrylic polymer is a copolymer of a copolymerizing component [I] which contains 40% by weight to 93% by weight of an aromatic ring-containing monomer (a1), and 7% by weight to 60% by weight of a hydroxyl group-containing monomer (a2),

the acrylic polymer has a weight-average molecular weight of 200,000 or less,

the light scattering particle has a volume concentration V relative to the adhesive layer of 3% to 35%,

the light scattering particle has a refractive index of 1.4 to 1.49, and

an acrylic adhesive composition as a component other than the light scattering particle in the adhesive layer has a refractive index of 1.52 to 1.67.

Advantageous Effects of Invention

According to the present invention, there can be provided an optical layered body which is capable of realizing a light source device having excellent light extraction efficiency, and a method for producing the same.

Brief Description of Drawings

FIG. 1 is a cross-sectional view schematically illustrating a cross section of an optical layered body according to an embodiment of the present invention cut along a flat plane parallel to a thickness direction thereof.
FIG. 2 is a graph illustrating the relationship between the mean free path in an adhesive layer according to an example and the particle diameter of light scattering particles contained in the adhesive layer.
FIG. 3 is a cross-sectional view schematically illustrating a cross section of an example of a light source device including an optical layered body according to an embodiment of the present invention cut along a flat plane parallel to a thickness direction thereof.
FIG. 4 is a graph illustrating the relationship between the concentration of light scattering particles obtained in Reference Example 1 and the ratio D1/L1.

Description of Embodiments

Hereinafter, the present invention will be described in detail with reference to embodiments and examples. However, the present invention is not limited to the following embodiments and examples, and may be freely modified and practiced without departing from the scope of claims of the present invention and the scope of their equivalents.

As described herein, a "solvent" is used as a term which includes not only a medium which constitutes a solution in which a solute is dissolved, but also a medium which constitutes a suspension (including a slurry) in which a dispersed material is dispersed, unless otherwise stated.

As described herein, the "compatibility" between a certain substance and another certain substance refers, unless otherwise stated, to properties in which when those substances are mixed with, if necessary, a solvent to produce a solution or a suspension, these are not gelled or separated, and maintain a uniform state.

As described herein, the average particle diameter of particles refers to a volume-average particle diameter, unless otherwise stated. The volume-average particle diameter is a particle diameter at a cumulative volume calculated from the small diameter side of 50% in a particle diameter distribution measured by a laser diffraction method. As the measuring device therefor, a dynamic light scattering particle size distribution analyzer (Nanotrac Wave-EX150 manufactured by Nikkiso Co., Ltd.) may be used.

As described herein, unless otherwise stated, (meth)acryl is a term which encompasses acryl and methacryl; (meth)acryloyl is a term which encompasses acryloyl and methacryloyl; (meth)acrylate is a term which encompasses acrylate and methacrylate; an acrylic polymer means a polymer obtained by polymerizing a monomer component which contains at least one kind of (meth)acrylic monomer; and a (meth)acrylic monomer is a term which encompasses (meth)acrylic acid and (meth)acrylate.

[1. Summary of Optical Layered Body]

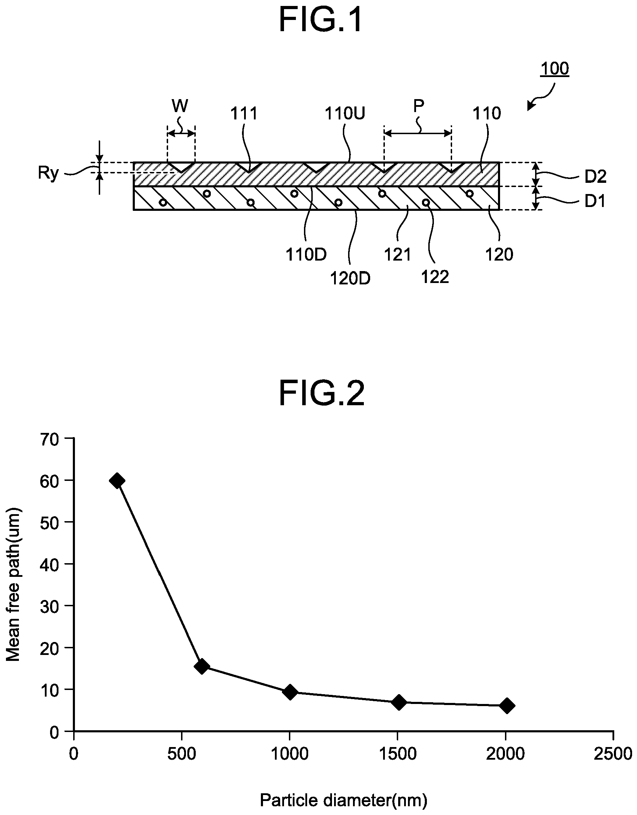

FIG. 1 is a cross-sectional view schematically illustrating a cross section of an optical layered body according to an embodiment of the present invention cut along a flat plane parallel to a thickness direction thereof.

As illustrated in FIG. 1, an optical layered body 100 according to the present embodiment includes a substrate 110, and an adhesive layer 120 formed on this substrate 110. The adhesive layer 120 contains an acrylic adhesive composition 121 and light scattering particles 122. Usually, such an optical layered body 100 is capable of adhering to an optional member at a surface 120D opposite to the substrate 110 of the adhesive layer 120. Also, a surface 110U of the substrate 110 opposite to the adhesive layer 120 may have a concavo-convex structure. In this embodiment, there is illustrated an example in which a plurality of recesses 111 formed by an embossing treatment is provided so that the surface 110U of the substrate 110 has a concavo-convex structure.

[2. Substrate]

As the material for constituting the substrate, a transparent resin is usually used. That the resin is "transparent" means that the resin has a light transmittance to a degree that is suitable for being used as an optical member. Usually, members (that is, a substrate, an adhesive layer, and an optional layer) included in an optical layered body is provided such that the entire optical layered body has a total light transmittance of 80% or more.

As the resin, a thermoplastic resin is preferably used. On the substrate constituted by the thermoplastic resin, the concavo-convex structure can be easily formed by an embossing treatment. As the thermoplastic resin, a resin containing a thermoplastic polymer may be used. Examples of the thermoplastic polymer may include: a polyester, such as polyethylene naphthalate, polyethylene terephthalate, polybutylene terephthalate, and a polyethylene terephthalate/isophthalate copolymer; a polyolefin, such as polyethylene, polypropylene, and polymethyl pentene; a polycycloolefin, such as a norbornene-based copolymer, a monocyclic olefin-based copolymer, a cyclic conjugated diene-based copolymer, and a hydrogenated product thereof; a polyethylene fluoride, such as polyvinyl fluoride, polyvinylidene fluoride, and polyethylene fluoride; a polyamide, such as nylon 6 and nylon 6,6; a vinyl polymer, such as polyvinyl chloride, a polyvinyl chloride/vinyl acetate copolymer, an ethylene-vinyl acetate copolymer, an ethylene-vinyl alcohol copolymer, polyvinyl alcohol, and vinylon; a cellulose-based polymer, such as cellulose triacetate and cellophane; an acrylic polymer, such as polymethyl methacrylate, polyethyl methacrylate, polyethyl acrylate, and polybutyl acrylate; a polystyrene; a polycarbonate; a polyarylate; and a polyimide. Among these, a polyester and a polycycloolefin are preferable, and a polycycloolefin is particularly preferable. Examples of a substrate containing a polycycloolefin may include "ZEONOR Film" manufactured by ZEON Corporation. As these polymers, one type thereof may be solely used, and two or more types thereof may also be used at any ratio.

The weight-average molecular weight (Mw) of the aforementioned polymers may be appropriately selected depending on an intended use of the optical layered body, and is preferably 10,000 or more, more preferably 15,000 or more, and particularly preferably 20,000 or more, and is preferably 100,000 or less, more preferably 80,000 or less, and particularly preferably 50,000 or less. When the weight-average molecular weight falls within such a range, the mechanical strength and molding processability of the substrate can be highly balanced.

The molecular weight distribution (weight-average molecular weight (Mw)/number-average molecular weight (Mn)) of the aforementioned polymers is preferably 1.2 or more, more preferably 1.5 or more, and particularly preferably 1.8 or more, and is preferably 3.5 or less, more preferably 3.0 or less, and particularly preferably 2.7 or less. When the molecular weight distribution is equal to or more than the aforementioned lower limit value, the productivity of the polymers can be enhanced, and production costs can thereby be reduced. Also, when the molecular weight distribution is equal to or less than the aforementioned upper limit value, the amount of low-molecular components is reduced, and relaxation during exposure to high temperature can thereby be suppressed. Consequently, the stability of the optical layered body can be enhanced.

The aforementioned weight-average molecular weight and number-average molecular weight may be measured as a value in terms of polyisoprene or polystyrene by gel permeation chromatography with cyclohexane used as a solvent. When the sample is not dissolved in cyclohexane during measurement, toluene may be used as a solvent.

The ratio of the polymers in the resin is preferably 50% by weight to 100% by weight, more preferably 70% by weight to 100% by weight, further preferably 80% by weight to 100% by weight, and particularly preferably 90% by weight to 100% by weight.

The resin may contain an optional component other than the polymer, as long as the effects of the present invention are not significantly impaired. Examples of the optional component may include additives such as: a colorant, such as a pigment and a dye; a plasticizer; a fluorescent brightener; a dispersant; a thermal stabilizer; a light stabilizer a ultraviolet ray absorber; an antistatic agent; an antioxidant; a lubricant; and a surfactant. As these components, one type thereof may be solely used, and two or more types thereof may also be used at any ratio.

The glass transition temperature of the resin may be appropriately selected depending on an intended use of the optical layered body, and is preferably 70°C or higher, and more preferably 80°C or higher, and is preferably 200°C or lower, and more preferably 150°C or lower. When the glass transition temperature is equal to or more than the lower limit value of the aforementioned range, the durability of the optical layered body at high temperature can be made favorable. When it is equal to or less than the upper limit value, the formation of the concavo-convex structure can be facilitated.

The refractive index of the resin as the material of the substrate is preferably 1.53 or more, and more preferably 1.60 or more. The refractive index of the resin is preferably equal to or more than the refractive index of the acrylic adhesive composition contained in the adhesive layer. Furthermore, a difference between the refractive index of the resin and the refractive index of the acrylic adhesive composition is preferably 0.05 or less, and more preferably 0.02 or less. When the refractive index of the resin as the material of the substrate falls within the aforementioned range, loss of light at the interface between the substrate and the adhesive layer can be reduced, and the light extraction efficiency can be enhanced when the optical layered body according to the present invention is provided to an organic EL element.

As the substrate, a film is usually used. When a film is used as the substrate, the substrate may be a single-layer film including one layer, or may be a multi-layer film including two or more layers.

The thickness D2 (see FIG. 1) of the substrate may be set depending on the use application of the optical layered body. When the substrate is a film, the thickness D2 of the substrate is preferably 5 μm or more, more preferably 10 μm or more, and particularly preferably 20 μm or more, and is preferably 200 μm or less, more preferably 100 μm

or less, and particularly preferably 75 μm or less.

The surface of the substrate opposite to the adhesive layer may have a concavo-convex structure. The concavo-convex structure may contain concave portions which are recessed below the surroundings like the recesses 111 illustrated in FIG. 1, may contain convex portions which project above the surroundings, and may also contain a combination of the concave portions and the convex portions. When the surface of the substrate has such a concavo-convex structure, the gloss of the surface of the substrate opposite to the adhesive layer can be suppressed. Therefore, the visual texture (mat properties or the like) of the optical layered body can be controlled. The mat properties refer to the visual texture of suppressed gloss. Since the concavo-convex structure allows the design of the surface of the substrate to be freely set, the aesthetic appearance of the optical layered body can be improved. Furthermore, an adequately formed concavo-convex structure can further improve the extraction efficiency of light which passes through the surface having this concavo-convex structure.

The shape of the concave portions or the convex portions contained in the concavo-convex structure may be set to any shape. Examples thereof may include dot-like, liner, and planer shapes. Examples of the shape of the dot-like concave or convex portions may include a pyramid, a cone, and part of a spherical surface. Furthermore, examples of the shape of the linear concave or convex portions may include straight linear and curvilinear shapes. The concavo-convex structure usually contains a plurality of concave portions or convex portions. The shapes of these concave portions and convex portions may be the same as or different from each other. Among these, the shape of the concave portions or convex portions contained in the concavo-convex structure is preferably a dot-like shape.

It is preferable that the maximum height Ry (see FIG. 1) of the concavo-convex structure satisfies a specific relationship with the thickness D2 of the substrate. Specifically, Ry/D2 is preferably more than 0.05, more preferably 0.07 or more, and particularly preferably 0.1 or more, and is preferably less than 0.25, more preferably 0.23 or less, and particularly preferably 0.2 or less. The maximum height Ry of the concavo-convex structure refers to a maximum value among the depths of the concave portions and the heights of the convex portions which are contained in the concavo-convex structure. When the maximum height Ry of the concavo-convex structure is set as described above, the gloss of the surface having the concavo-convex structure can be suppressed, and the aesthetic appearance of the optical layered body can be improved. When the maximum height Ry of the concavo-convex structure is set as described above, the concavo-convex structure can be easily formed by an embossing treatment.

As previously described, the substrate may have a multi-layer structure which includes two or more layers. For example, a substrate having a multi-layer structure which includes a layer near the adhesive layer (a support layer) and a layer having a concavo-convex structure (a concavo-convex structure layer) is advantageous, because precise formation of the shape of the concavo-convex structure for enhancing light extraction efficiency is facilitated. However, the optical layered body according to the present invention can sufficiently achieve the enhancement of light extraction efficiency with the light scattering by the adhesive layer. Therefore, from the viewpoint of taking advantage of the enhancement effect of light extraction efficiency by the adhesive layer, the substrate 110 preferably has a single-layer structure which includes only one layer as illustrated in FIG. 1. The optical layered body having such a single-layer structure can avoid large thickness of the substrate due to the increased number of layers, and can also avoid large number of manufacturing steps for forming the concavo-convex structure. Furthermore, when the substrate has a single-layer structure, it is particularly preferable that Ry/D2 falls within the aforementioned range. With this feature, the concavo-convex structure can be easily formed on the substrate by an embossing treatment while reducing thickness of the substrate.

The pitch P (see FIG. 1) of the concave portion or the convex portion contained in the concavo-convex structure is preferably 20 μm or more, more preferably 100 μm or more, and particularly preferably 200 μm or more, and is preferably 3 mm or less, more preferably 1.5 mm or less, and particularly preferably 1 mm or less. When the pitch P of the concave portion or the convex portion falls within the aforementioned range, the gloss on the surface of the substrate having the concavo-convex structure is suppressed, so that the aesthetic appearance of the optical layered body can be easily improved.

The width W (see FIG. 1) of the concave portion or the convex portion contained in the concavo-convex structure is preferably 5 μm or more, more preferably 25 μm or more, and particularly preferably 50 μm or more, and is preferably 1.5 mm or less, more preferably 0.75 mm or less, and particularly preferably 0.5 mm or less. When the width W of the concave portion or the convex portion falls within the aforementioned range, the gloss on the surface of the substrate having the concavo-convex structure is suppressed, so that the aesthetic appearance of the optical layered body can be easily improved.

When the concavo-convex structure contains a plurality of concave portions and convex portions, the size of these concave portions and convex portions may be the same as or different from each other.

The method for producing the substrate may be any method. For example, when the substrate is produced from a thermoplastic resin, the substrate may be produced by molding a resin into a film shape by a molding method, such as a melt molding method or a solution casting method. Further specifically, the melt molding method may be classified into, for example, an extrusion molding method, a press molding method, an inflation molding method, an injection molding method, a blow molding method, and a stretch molding method. Among these methods, an extrusion molding method, an inflation molding method, and a press molding method are preferable for obtaining a substrate which is excellent in mechanical strength and surface precision. Among these, an extrusion molding method is particularly preferable for producing the substrate in an efficient and simple manner.

The method for producing the substrate may include a step of subjecting the substrate to a stretching process. This allows production of a stretched film as the substrate. Accordingly, a variety of optical and mechanical properties can be expressed in the substrate. Examples of the stretching method when stretching a long-length film may include: a uniaxial stretching method, such as a method of uniaxially stretching a film in a longitudinal direction by taking advantage of a difference in peripheral speed of rolls, and a method of uniaxially stretching a film in a width direction using a tenter stretching machine; a biaxial stretching method, such as a simultaneous biaxial stretching method of simultaneously stretching a film in a longitudinal direction and in a width direction, and a sequential biaxial stretching method of stretching a film in one of a longitudinal direction and a width direction and thereafter stretching in the other direction; and a stretching method of a film in an oblique direction using a tenter stretching machine. The oblique direction herein indicates a direction that is neither parallel nor orthogonal to the width direction of a film. The long-length film refers to a film having a length that is usually 5 times or more longer than the width, preferably a length that is 10 times or more longer than the width, and specifically to a film having a length to a degree that allows a film to be wound up into a roll shape for storage or conveyance.

The method for producing the substrate may include a step of forming the concavo-convex structure on the surface of the substrate. The forming method of the concavo-convex structure may be any method. For example, as described in Patent Literature 1, an ultraviolet curable resin and a mold may be used to form the concavo-convex structure. Alternatively, irradiation with a laser beam may be performed to form the concavo-convex structure. In particular, the concavo-convex structure is preferably formed by an embossing treatment.

In the embossing treatment, a mold is generally pressed against the surface of the substrate in a state of being heated, so that the concavo-convex structure is formed on the surface. As the mold, there may be used a member which includes a surface having a concavo-convex shape corresponding to a concave-convex structure desired to be formed on the surface of the substrate opposite to the adhesive layer. Specific examples of the mold may include a roll or a drum having a desired concavo-convex shape on its circumferential surface. The substrate is pressed against the above-described mold so that the concavo-convex structure of the mold is transferred on the surface of the substrate, thereby to form a desired concavo-convex structure on the surface of the substrate.

When the substrate is pressed with a mold, the substrate may be placed between a mold which is capable of pressing the surface of the substrate opposite to the adhesive layer and a support which is capable of pressing the surface of the substrate on the adhesive layer side, for performing pressing. As the support, there may be used a member which includes a surface corresponding to the shape of the surface of the substrate on the adhesive layer side. Since the surface of the substrate on the adhesive layer side is usually formed to be a flat plane, the shape of the surface of the support is set to be a flat surface or a smooth curved surface. Specific examples of the support may include a roll or drum having a smooth circumferential surface. Therewith the concavo-convex structure can be stably formed even when the substrate is thin.

In the embossing treatment, the method for heating the substrate may be any method. For example, the mold or the support may be heated so that the substrate is heated by the heated mold or support. A heater which is prepared separately from the mold or the support may also be used for heating the substrate. In the embossing treatment, the substrate is usually pressed by the mold in a state of being heated to a temperature equal to or higher than the glass transition temperature of the resin contained in the substrate.

With the embossing treatment, the concavo-convex structure can be formed on the substrate only by pressing with the mold, and thereby a simple production method and reduced costs can be achieved. The concavo-convex structure can be easily formed even on a thin substrate. In general, it is difficult to form a deep concave portion on a thin substrate by the embossing treatment. However, when the concave portion is within an extent such that the aforementioned "Ry/D2" falls within approximately the aforementioned range, the concave portion can be easily formed by the embossing treatment. Therefore, a thin substrate can be adopted. Thus, it can be expected that the thickness of the entire optical layered body will be as thin as, for example, 50 $\mu$m or less. Furthermore, since the ultraviolet curable resin described in Patent Literature 1 tended to have low flexibility after curing, it was difficult to obtain a flexible substrate. However, according to the embossing treatment, a flexible substrate can be achieved.

The surface of the substrate on the adhesive layer side is usually formed as a flat plane. However, when the concavo-convex structure is formed on the surface opposite to the adhesive layer by the embossing treatment as described above, small undulations are sometimes formed on the surface of the substrate on the adhesive layer side, causing smoothness to be lowered. According to studies by the present inventor, it is inferred that the undulations are caused by the shrinkage of the substrate which occurs when the substrate is cooled after the embossing treatment. In a conventional adhesive layer having a high refractive index, a large amount of inorganic oxide particles, such as zirconia, is contained for enabling high refraction, causing the adhesive layer to become hard. Consequently, it was difficult to bring the adhesive layer into optical intimate contact with the substrate on the surface including such undulations. However, the adhesive layer according to the present invention can achieve a high refractive index even when the amount of inorganic oxide particles is zero or small. This prevents the adhesive layer from becoming excessively hard. Thus, the optical intimate contact between the substrate and the adhesive layer can be easily achieved.

[3. Adhesive Layer]

The adhesive layer is a layer which contains an acrylic adhesive composition and light scattering particles. The adhesive layer usually consists only of the acrylic adhesive composition and the light scattering particles. Therefore, the composition as a component other than the light scattering particles among the components contained in the adhesive layer is usually the acrylic adhesive composition. In the adhesive layer, the light scattering particles are dispersed in the acrylic adhesive composition, and light which passes through the adhesive layer is reflected at the interface between the acrylic adhesive composition and the light scattering particles. This reflection causes light to be scattered in the adhesive layer. Accordingly, when the optical layered body according to the present invention is provided to an organic EL element, light extraction efficiency can be improved. Since the adhesive layer has adhesiveness, the optical layered body can be bonded to any optional member by bonding the surface of the adhesive layer opposite to the substrate to the optional member.

[3.1. Acrylic Adhesive Composition]

The acrylic adhesive composition may contain an acrylic polymer, and as necessary, an optional component. The acrylic adhesive composition is usually capable of acting as a binder in the adhesive layer. Therefore, the adhesive layer can express adhesiveness by the action of the acrylic adhesive composition. The light scattering particles can be retained in the adhesive layer by the action of the acrylic adhesive composition.

[3.1.1. Acrylic Polymer]

The acrylic polymer is a copolymer of a copolymerizing component [I] which contains an aromatic ring-containing monomer (a1) and a hydroxyl group-containing monomer (a2). The aforementioned copolymerizing component [I] may contain, as necessary, a (meth)acrylic acid alkyl ester-based monomer (a3), and an optional copolymerizable monomer (a4). This acrylic polymer can have a high refractive index. Therefore, the refractive index of the acrylic adhesive composition containing the acrylic polymer can be easily increased.

The aromatic ring-containing monomer (a1) is a compound which has one or more aromatic rings and one or more ethylene-based unsaturated groups in one molecule.

Examples of a functional group which contains the ethylene-based unsaturated groups may include a (meth)acryloyl group, a crotonoyl group, a vinyl group, and an allyl group. Among these, a (meth)acryloyl group is preferable in terms of excellent reactivity.

Examples of the aromatic rings may include a benzene ring, a naphthalene ring, an anthracene ring, a biphenyl ring, and a fluorene ring. The number of aromatic rings per molecule of the aromatic ring-containing monomer (a1) may be one, and may also be two or more. The aromatic ring-containing monomer (a1) is preferably a compound which contains one aromatic ring per molecule from the viewpoint of balancing adhesive properties. The aromatic ring-containing monomer (a1) is preferably a compound which contains two aromatic rings per molecule from the viewpoint of efficiently controlling the refractive index and birefringence of the adhesive layer.

Such an aromatic ring-containing monomer (a1) is preferably a (meth)acrylic monomer.

Examples of the aromatic ring-containing monomer (a1) may include benzyl (meth)acrylate, benzyloxyethyl (meth)acrylate, phenoxyethyl (meth)acrylate, phenoxydiethylene glycol (meth)acrylate, ethylene oxide-modified cresol (meth)acrylate, ethylene oxide-modified nonylphenol (meth)acrylate, (meth)acrylic acid biphenyloxyethyl ester, and styrene. Among these, benzyl (meth)acrylate and phenoxyethyl (meth)acrylate are particularly preferable. As the aromatic ring-containing monomers (a1), one type thereof may be solely used, and two or more types thereof may also be used at any ratio.

The amount of the aromatic ring-containing monomer (a1) in the copolymerizing component [I], relative to the total copolymerizing component [I] being 100% by weight, is usually 40% by weight or more, preferably 50% by weight or more, further preferably 55% by weight or more, and particularly preferably 60% by weight or more, and is usually 93% by weight or less, preferably 90% by weight or less, and more preferably 85% by weight or less. When the amount of the aromatic ring-containing monomer (a1) is equal to or more than the lower limit value of the aforementioned range, the refractive index of the acrylic adhesive composition can be sufficiently increased. When it is equal to or less than the upper limit value, the adhesiveness of the acrylic adhesive composition can be made favorable.

The hydroxyl group-containing monomer (a2) is a monomer which contains a hydroxyl group. In particular, a (meth)acrylic monomer which contains a hydroxyl group is preferable.

Examples of the hydroxyl group-containing monomer (a2) may include: an acrylic acid hydroxyalkyl ester, such as 2-hydroxyethyl (meth)acrylate, 4-hydroxybutyl (meth)acrylate, 5-hydroxypentyl (meth)acrylate, 6-hydroxyhexyl (meth)acrylate, and 8-hydroxyoctyl (meth)acrylate; a caprolactone-modified monomer, such as caprolactone-modified 2-hydroxyethyl (meth)acrylate; an oxyalkylene-modified monomer, such as diethylene glycol (meth)acrylate and polyethylene glycol (meth)acrylate; a primary hydroxyl group-containing monomer, such as 2-acryloyloxyethyl 2-hydroxyethyl phthalate, N-methylol (meth)acrylamide, and hydroxyethyl acrylamide; a secondary hydroxyl-group-containing monomer, such as 2-hydroxypropyl (meth)acrylate, 2-hydroxybutyl (meth)acrylate, and 3-chloro 2-hydroxypropyl (meth)acrylate; and a tertiary hydroxyl group-containing monomer, such as 2,2-dimethyl 2-hydroxyethyl (meth)acrylate. As the hydroxyl group-containing monomers (a2), one type thereof may be solely used, and two or more types thereof may also be used at any ratio.

Among the hydroxyl group-containing monomers (a2), a primary hydroxyl group-containing monomer is preferable in terms of excellent reactivity with a crosslinking agent. Furthermore, a monomer having a hydroxyl group at a terminal of its molecular chain is likely to exhibit more favorable antistatic performance, and is preferable. Furthermore, use of 2-hydroxyethyl (meth)acrylate is particularly preferable, because it can be easily produced with low amount of impurities such as di(meth)acrylate.

It is preferable that the hydroxyl group-containing monomer (a2) has low content ratio of di(meth)acrylate as an impurity. Specifically, the content ratio of di(meth)acrylate in the hydroxyl group-containing monomer (a2) is preferably 0.5% by weight or less, more preferably 0.2% by weight or less, and further preferably 0.1% by weigh or less.

Particularly preferable examples of the hydroxyl group-containing monomer (a2) may include 2-hydroxyethyl acrylate and 2-hydroxypropyl acrylate.

The amount of the hydroxyl group-containing monomer (a2) in the copolymerizing component [I], relative to the total copolymerizing component [I] being 100% by weight, is usually 7% by weight or more, and preferably 10% by weight or more, and is usually 60% by weight or less, preferably 50% by weight or less, more preferably 40% by weight or less, and particularly preferably 35% by weight or less. When the amount of the hydroxyl group-containing monomer (a2) is equal to or more than the lower limit value of the aforementioned range, compatibility between the acrylic polymer and particles (for example, the light scattering particles and the inorganic oxide particles) becomes favorable, and thereby dispersibility of the particles in the adhesive layer can be made favorable. When the amount of the hydroxyl group-containing monomer (a2) is equal to or less than the upper limit value, the amount of the aromatic ring-containing monomer (a1) can be made relatively large, and thereby high refractive index of the acrylic adhesive composition can be obtained.

The weight ratio (a1):(a2) between the aromatic ring-containing monomer (a1) and the hydroxyl group-containing monomer (a2) is preferably 93:7 to 40:60, more preferably 90:10 to 50:50, and further preferably 85:15 to 60:40. When the amount of the aromatic ring-containing monomer (a1) relative to the hydroxyl group-containing monomer (a2) is increased as described above, refractive index of the acrylic adhesive composition can be effectively increased. When the amount of the aromatic ring-containing monomer (a1) relative to the hydroxyl group-containing monomer (a2) is decreased as described above, compatibility between the acrylic polymer and particles (for example, the light scattering particles and the inorganic oxide particles) is made favorable, and thereby dispersibility of the particles in the adhesive layer can be made favorable.

As the (meth)acrylic acid alkyl ester-based monomer (a3), the number of carbon atoms of the alkyl group possessed by the (meth)acrylic acid alkyl ester-based monomer (a3) preferably falls within a specific range. Specifically, the number of carbon atoms of the alkyl group is preferably 1 or more, and more preferably 4 or more, and is preferably 20 or less, more preferably 12 or less, and particularly preferably 8 or less.

Examples of the (meth)acrylic acid alkyl ester-based monomer (a3) may include methyl (meth)acrylate, ethyl (meth)acrylate, n-butyl (meth)acrylate, iso-butyl (meth)acrylate, tert-butyl (meth)acrylate, n-propyl (meth)acrylate, n-hexyl (meth)acrylate, 2-ethylhexyl (meth)acrylate, n-octyl (meth)acrylate, isodecyl (meth)acrylate, lauryl (meth)acrylate, cetyl (meth)acrylate, stearyl (meth)acrylate, cyclohexyl (meth)acrylate, and isobornyl (meth)acrylate. As the (meth)acrylic acid alkyl ester-based monomers (a3), one type thereof may be solely used, and two or more types thereof may also be used at any ratio.

Among the (meth)acrylic acid alkyl ester-based monomers (a3), n-butyl (meth)acrylate and 2-ethylhexyl (meth)acrylate are preferable in terms of copolymerization properties, adhesive properties, handleability, and raw material availability. Furthermore, n-butyl (meth)acrylate is particularly preferable in terms of excellent durability.

The amount of the (meth)acrylic acid alkyl ester-based monomer (a3) in the copolymerizing component [I], relative to the total copolymerizing component [I] being 100% by weight, is preferably 0 to 40% by weight, more preferably 0 to 35% by weight, and further preferably 0 to 30% by weight. When the (meth)acrylic acid ester-based monomer (a3) is used within such a range, adhesiveness of the adhesive layer can be effectively enhanced.

Examples of the optional copolymerizable monomer (a4) may include a monomer other than the aforementioned monomers (a1) to (a3). Examples of such a monomer may include a functional group-containing monomer, such as a carboxyl group-containing monomer, an amino group-containing monomer, an acetoacetyl group-containing monomer, an isocyanate group-containing monomer, and a glycidyl group-containing monomer.

Examples of the carboxyl group-containing monomer may include (meth)acrylic acid, acrylic acid dimer, crotonic acid, maleic acid, maleic anhydride, fumaric acid, citraconic acid, glutaconic acid, itaconic acid, acrylamide N-glycolic acid, and cinnamic acid. Among these, (meth)acrylic acid is preferable.

Examples of the amino group-containing monomer may include t-butylaminoethyl (meth)acrylate, ethylaminoethyl (meth)acrylate, dimethylaminoethyl (meth)acrylate, and diethylaminoethyl (meth)acrylate.

Examples of the acetoacetyl group-containing monomer may include 2-(acetoacetoxy)ethyl (meth)acrylate, and allyl acetoacetate.

Examples of the isocyanate group-containing monomer may include 2-acryloyloxyethyl isocyanate, 2-methacryloyloxyethyl isocyanate, and alkylene oxide adducts thereof.

Examples of the glycidyl group-containing monomer may include glycidyl (meth)acrylate and allylglycidyl (meth)acrylate.

When the molecular weight of the acrylic polymer is desired to be increased, a compound having two or more ethylene-based unsaturated groups may be used as the optional copolymerizable monomer (a4). Example of the compound having two or more ethylene-based unsaturated groups may include ethylene glycol di(meth)acrylate, diethylene glycol di(meth)acrylate, triethylene glycol di(meth)acrylate, polyethylene glycol di(meth)acrylate, propylene glycol di(meth)acrylate, and divinylbenzene.

As the optional copolymerizable monomer (a4), there may be used an acid group-containing monomer such as a carboxyl group-containing monomer. However, from the viewpoint of corrosion resistance, an acid group-containing monomer is preferably not used as the optional copolymerizable monomer (a4).

Further examples of the optional copolymerizable monomer (a4) may include a monomer containing an alkoxy group and an oxyalkylene group, such as 2-methoxyethyl (meth)acrylate, 2-ethoxyethyl (meth)acrylate, 3-methoxybutyl (meth)acrylate, 2-butoxyethyl (meth)acrylate, 2-butoxydiethylene glycol (meth)acrylate, methoxydiethylene glycol (meth)acrylate, methoxytriethylene glycol (meth)acrylate, ethoxydiethylene glycol (meth)acrylate, methoxydipropylene glycol (meth)acrylate, methoxypolyethylene glycol (meth)acrylate, octoxypolyethylene glycol-polypropylene glycol-mono(meth)acrylate, lauroxypolyethylene glycol mono(meth)acrylate, and stearoxypolyethylene glycol mono(meth)acrylate; an alkoxyalkyl (meth)acrylamide-based monomer, such as methoxymethyl(meth)acrylamide, ethoxymethyl(meth)acrylamide, propoxymethyl(meth)acrylamide, isopropoxymethyl(meth)acrylamide, n-butoxymethyl(meth)acrylamide, and isobutoxymethyl(meth)acrylamide; a (meth)acrylamide-based monomer, such as (meth)acryloylmorpholine, dimethyl(meth)acrylamide, diethyl(meth)acrylamide, and (meth)acrylamide N-methylol(meth)acrylamide; acrylonitrile, methacrylonitrile, vinyl acetate, vinyl propionate, vinyl stearate, vinyl chloride, vinylidene chloride, alkyl vinyl ether, vinyl toluene, vinyl pyridine, vinyl pyrrolidone, itaconic acid dialkyl ester, fumaric acid dialkyl ester, allyl alcohol, acryl chloride, methyl vinyl ketone, N-acrylamide methyl trimethylammonium chloride, allyl trimethylammonium chloride, and dimethyl allyl vinyl ketone.

As the optional copolymerizable monomers (a4), one type thereof may be solely used, and two or more types thereof may also be used at any ratio.

The amount of the optional copolymerizable monomer (a4) in the copolymerizing component [I], relative to the total copolymerizing component [I] being 100% by weight, is preferably 0 to 40% by weight, more preferably 0 to 30% by weight, and further preferably 0 to 20% by weight. When the optional copolymerizable monomer (a4) is used within such a range, the amount of the aromatic ring-containing monomer (a1) can be made relatively large, and thereby refractive index of the acrylic adhesive composition can be effectively increased.

The weight-average molecular weight of the acrylic polymer is usually 200,000 or less, preferably 180,000 or less, more preferably 160,000 or less, and particularly preferably 150,000 or less. When the weight-average molecular weight of the acrylic polymer is equal to or less than the upper limit value of the aforementioned range, compatibility between the acrylic polymer and particles (for example, the light scattering particles and the inorganic oxide particles) becomes favorable, and thereby dispersibility of the particles in the adhesive layer can be made favorable. The weight-average molecular weight of the acrylic polymer is not limited as long as the effects of the present invention are not significantly impaired, and is usually 10,000 or more.

The molecular weight distribution (weight-average molecular weight/number-average molecular weight) of the acrylic polymer is preferably 10 or less, more preferably 8 or less, further preferably 6 or less, and particularly preferably 5 or less. When the molecular weight distribution of the acrylic polymer is equal to or less than the upper limit value of the aforementioned range, the adhesive layer can have favorable durability. Although the lower limit of the molecular weight distribution of the acrylic polymer is not limited, it is usually 1.1 or more in terms of production limitations.

The weight-average molecular weight and the number-average molecular weight of the acrylic polymer may be measured by high performance liquid chromatography ("Waters 2695 (main body)" and "Waters 2414 (detector)" manufactured by Nihon Waters K.K.), using three columns: Shodex GPC KF-806L (exclusion limit molecular weight: $2 \times 10^7$, separation range: 100 to $2 \times 10^7$, the number of theoretical plates: 10,000 plates/column, filler material properties:

styrene-divinyl benzene copolymer, filler particle diameter: 10 $\mu$m) connected in series. The weight-average molecular weight and the number-average molecular weight may be calculated in terms of a standard polystyrene molecular weight.

The glass transition temperature of the acrylic polymer is preferably -70°C or higher, more preferably - 50°C or higher, and particularly preferably -40°C or higher, and is preferably 10°C or lower, more preferably 5°C or lower, and particularly preferably 0°C or lower. When the glass transition temperature of the acrylic polymer is equal to or more than the lower limit value of the aforementioned range, heat resistance of the adhesive layer can be enhanced. When it is equal to or less than the upper limit value of the aforementioned range, excessive increase of adhesiveness of the adhesive layer can be suppressed.

The glass transition temperature of the acrylic polymer as a copolymer may be calculated according to Fox's formula indicated in the following (1).

$$1/Tg = Wa/Tga + Wb/Tgb + \cdots Wn/Tgn \quad (1)$$

Tg: glass transition temperature (K) of copolymer
Tga: glass transition temperature (K) of homopolymer of monomer A
Wa: weight fraction of monomer A
Tgb: glass transition temperature (K) of homopolymer of monomer B
Wb: weight fraction of monomer B
Tgn: glass transition temperature (K) of homopolymer of monomer N
Wn: weight fraction of monomer N

$$(Wa + Wb + \cdots + Wn = 1)$$

The method for producing the acrylic polymer may be any method as long as it is capable of obtaining a desired acrylic polymer. Usually, the acrylic polymer may be produced by polymerizing monomer components such as the aromatic ring-containing monomer (a1) and the hydroxyl group-containing monomer (a2), as well as, as necessary, the (meth)acrylic acid alkyl ester-based monomer (a3) and the optional copolymerizable monomer (a4). Examples of the polymerization method to be adopted may include solution radical polymerization, suspension polymerization, bulk polymerization, and emulsion polymerization. Among these, solution radical polymerization is preferable.

As the polymerization condition, an appropriate condition which allows a polymerization reaction to proceed may be adopted. For example, the acrylic polymer may be produced by mixing or dropping, into an organic solvent, polymerization monomers containing the aromatic ring-containing monomer (a1), the hydroxyl group-containing monomer (a2), the (meth)acrylic acid alkyl ester-based monomer (a3), and the optional copolymerizable monomer (a4), as well as a polymerization initiator, and performing radical polymerization. The aforementioned polymerization may be performed under the condition of a reflux state or 50°C to 90°C. The polymerization time of the aforementioned polymerization is usually 2 hours to 20 hours.

Examples of the organic solvent used for such polymerization may include an aromatic hydrocarbon solvent, such as toluene and xylene; an ester solvent, such as methyl acetate, ethyl acetate, and butyl acetate; an aliphatic alcohol solvent, such as n-propyl alcohol and isopropyl alcohol; and a ketone solvent, such as acetone, methyl ethyl ketone, methyl isobutyl ketone, and cyclohexanone. One type thereof may be solely used, and two or more types thereof may also be used at any ratio.

Examples of the polymerization initiator used for such polymerization may include an azo-based polymerization initiator, such as azobisisobutyronitrile and azobisdimethylvaleronitrile; and a peroxide-based polymerization initiator, such as benzoyl peroxide, lauroyl peroxide, di-t-butyl peroxide, and cumene hydroperoxide. One type thereof may be solely used, and two or more types thereof may also be used at any ratio.

The amount of the acrylic polymer in the acrylic adhesive composition, relative to the total acrylic adhesive composition being 100% by weight, is preferably 65% by weight to 100% by weight, more preferably 80% by weight to 100% by weight, and particularly preferably 85% by weight to 100% by weight. When the amount of the acrylic polymer is made large as described above, both the adhesiveness and the refractive index of the acrylic adhesive composition can be effectively increased.

[3.1.2. Optional Component]

The acrylic adhesive composition may further contain an optional component, in combination with the aforementioned acrylic polymer.

(Inorganic Oxide Particles)

For example, the acrylic adhesive composition may contain inorganic oxide particles. The inorganic oxide particles have a relatively high refractive index. Therefore, use of the inorganic oxide particles can further increase the refractive index of the acrylic adhesive composition.

The inorganic oxide particles are particles which contain an inorganic oxide. Examples of the inorganic oxide may include a metal oxide and a non-metal oxide. Among these, a metal oxide is preferable. In particular, preferable inorganic oxide particles are particles which contain a metal oxide, and a reactive functional group-containing organic substance which modifies the surface of the metal oxide. More specifically, preferable inorganic oxide particles are coated particles which contain particles of a metal oxide, and a reactive functional group-containing organic substance which modifies the surface of the particles (hereinafter, these particles may be appropriately referred to as "reactive modified metal oxide particles"). The reactive functional group may be in a state of having an interaction, such as a hydrogen bond, with a metal oxide. Alternatively, the reactive functional group may not be in such a state but in a state of being allowed to have an interaction with another substance.

A preferable metal oxide is a metal oxide which may be generally used as a filler in a resin. Specific examples of the metal oxide may include a zirconium oxide ($ZrO_2$: zirconia), a titanium oxide ($TiO_2$: titania), an aluminum oxide ($Al_2O_3$: alumina), an iron oxide ($Fe_2O_3$, $Fe_3O_4$), a copper oxide (CuO), a zinc oxide (ZnO), an yttrium oxide ($Y_2O_3$: yttria), a niobium oxide ($Nb_2O_5$), a molybdenum oxide ($MoO_3$, $MoO_2$), an indium oxide ($In_2O_3$), a tin oxide ($SnO_2$), a tantalum oxide ($Ta_2O_5$, $TaO_2$), a tungsten oxide ($WO_3$, $WO_2$), a lead oxide (PbO), a bismuth oxide ($Bi_2O_3$), a cerium oxide ($CeO_2$: ceria), an antimony oxide ($Sb_2O_3$, $Sb_2O_5$), a tin-doped indium oxide (ITO), an antimony-doped tin oxide (ATO), a fluorine-doped tin oxide (FTO), a phosphorus-doped tin oxide (PTO), a zinc antimonate (AZO), an indium-doped zinc oxide (IZO), an aluminum-doped zinc oxide, and a gallium-doped zinc oxide.

A preferable non-metal oxide is a non-metal oxide which may be generally used as a filler in a resin. Specific examples of the non-metal oxide may include a silicon oxide ($SiO_2$: silica) and a boron oxide ($B_2O_3$).

As the aforementioned inorganic oxides such as metal oxides and non-metal oxides, one type thereof may be solely used, and two or more types thereof may also be used at any ratio.

Among these inorganic oxides, an inorganic oxide having a high refractive index is preferable. Specifically, an inorganic oxide having a refractive index of 1.5 or more is preferable. Use of such an inorganic oxide having a high refractive index can reduce the amount of the inorganic oxide particles in the acrylic adhesive composition. Therefore, the acrylic adhesive composition can have enhanced adhesiveness, and can be softened. Examples of the inorganic oxide having a high refractive index may include a titanium oxide (refractive index: 2.3 to 2.7), a potassium titanate (refractive index: 2.68), a zirconium oxide (refractive index: 2.05 to 2.4), and a zinc oxide (refractive index: 2.01 to 2.03). Among these, a zirconium oxide and a titanium oxide are preferable, because the acrylic adhesive composition having a high refractive index can be easily obtained.

Examples of the reactive functional group in the reactive functional group-containing organic substance may include a hydroxyl group, a phosphate group, a carboxyl group, an amino group, an alkoxy group, an isocyanate group, acid halide, acid anhydride, a glycidyl group, a chlorosilane group, and an alkoxysilane group. One type of them may be solely used, and two or more types thereof may also be used at any ratio.

As the reactive functional group-containing organic substance, an organic substance having an isocyanate group is preferable for enhancing the stability between a metal oxide and a substance around the metal oxide. Examples of the organic substance having an isocyanate group may include acryloxymethyl isocyanate, methacryloxymethyl isocyanate, acryloxyethyl isocyanate, methacryloxyethyl isocyanate, acryloxypropyl isocyanate, methacryloxypropyl isocyanate, and 1,1-bis(acryloxymethyl)ethyl isocyanate. One type of them may be solely used, and two or more types thereof may also be used at any ratio.

In the reactive modified metal oxide particles, the ratio of the reactive functional group-containing organic substance is preferably 1 part by weight to 40 parts by weight relative to 100 parts by weight of the metal oxide.

The volume-average particle diameter of the inorganic oxide particles is preferably 5 nm or more, more preferably 10 nm or more, and particularly preferably 20 nm or more, and is preferably 50 nm or less, more preferably 40 nm or less, and particularly preferably 30 nm or less. When the volume-average particle diameter of the inorganic oxide particles falls within the aforementioned range, an adhesive layer having less coloring and high light transmittance can be obtained, and furthermore, dispersion of particles is facilitated. When the inorganic oxide particles aggregate to form a secondary or higher level of the particles, the aforementioned range of the average particle diameter may be the range of a primary particle diameter.

Examples of the form for the inorganic oxide particles may include particulate powders, a paste, and a sol. Among these, the inorganic oxide particles are preferably in a form of a sol.

The method for producing the inorganic oxide particles may be any method. For example, the reactive modified metal oxide particles may be obtained as a suspension in which particles are dispersed in an organic solvent, by mixing particles of a metal oxide, a reactive functional group-containing organic substance, an organic solvent, and an optional additive for use as necessary, and further subjecting, as necessary, the obtained mixed composition to a treatment such as an ultrasonic treatment.

Examples of the organic solvent may include a ketone solvent, such as methyl ethyl ketone, methyl isobutyl ketone, acetone, and cyclohexanone; an aromatic hydrocarbon solvent, such as benzene, toluene, xylene, and ethyl benzene; an alcohol solvent, such as methanol, ethanol, isopropyl alcohol, n-butanol, and iso-butanol; an ether solvent, such as ethylene glycol monomethyl ether, ethylene glycol monoethyl ether, ethylene glycol monobutyl ether, diethylene glycol monomethyl ether, and diethylene glycol monoethyl ether; an ester solvent, such as ethyl acetate, butyl acetate, ethyl lactate, $\gamma$-butyrolactone, propylene glycol monomethyl ether acetate, and propylene glycol monoethyl ether acetate; and an amide solvent, such as dimethylformamide, N,N-dimethylacetoacetamide, and N-methylpyrrolidone. As the organic solvent, one type thereof may be solely used, and two or more types thereof may also be used at any ratio.

Examples of the optional additive may include a metal chelate agent. As the optional additive, one type thereof may be solely used, and two or more types thereof may also be used at any ratio.

When the reactive modified metal oxide particles are obtained as a suspension in which particles are dispersed in an organic solvent, it is preferable to adjust conditions such as the amount of the solvent, so that the suspension contains the reactive modified metal oxide particles in an amount of 1% by weight to 50% by weight. Since the suspension obtained in this manner as it is may be used for production of the acrylic adhesive composition, the production of the acrylic adhesive composition can be performed by simple procedures.

When the aforementioned mixed composition is prepared, it is preferable to mix the components using a mixing device such as a bead mill. By such mixing, a secondary or higher level of particles can be milled into the primary particle level, thereby allowing the surface to be treated in the state of a primary particles. As a result, the metal oxide particles can be subjected to a uniform surface treatment.

The mixed composition may further be subjected to an ultrasonic treatment as necessary. The ultrasonic treatment may be performed using an ultrasonic treatment apparatus such as an ultrasonic washer, an ultrasonic homogenizer, and an ultrasonic disperser. Such a treatment can provide a favorable suspension.

As the reactive modified metal oxide particles, commercially available particles as they are may also be used. The commercially available particles are supplied as a slurry which contains components such as a solvent and an additive in some cases. Such a slurry may be used as a material of the acrylic adhesive composition in the state of a slurry which contains such components as they are. Examples of the slurry of the reactive modified metal oxide particles which contain $ZrO_2$ as a metal oxide may include trade name "NANON5 ZR-010" (manufactured by Solar Co., Ltd., solvent: methyl ethyl ketone, particle content ratio 30%, surface-modifying organic substance having a reactive functional group: isocyanate having a polymerizable functional group, volume-average particle diameter 15 nm). Examples of the slurry of the reactive modified metal oxide particles which contain $TiO_2$ as a metal oxide may include trade name "NOD-742GTF" (manufactured by Nagase ChemteX Corporation, solvent: polyethylene glycol monomethyl ether, particle content ratio 30%, volume-average particle diameter 48 nm).

The ratio of the inorganic oxide particles in the acrylic adhesive composition is preferably 30 parts by weight or more, more preferably 40 parts by weight or more, and particularly preferably 50 parts by weight or more, and is preferably 130 parts by weight or less, more preferably 120 parts by weight or less, and particularly preferably 110 parts by weight or less, relative to 100 parts by weight of the acrylic polymer. When the amount of the inorganic oxide particles is equal to or more than the lower limit value of the aforementioned range, refractive index of the acrylic adhesive composition can be effectively increased. When it is equal to or less than the upper limit value of the aforementioned range, adhesiveness and flexibility of the acrylic adhesive composition can be effectively enhanced. However, from the viewpoint of facilitating the production of the optical layered body by facilitating the formation of the adhesive layer and facilitating the optical intimate contact between the adhesive layer and the substrate, the amount of the inorganic oxide particles in the acrylic adhesive composition is preferably small. Further, it is particularly preferable that the acrylic adhesive composition does not contain any inorganic oxide particles.

(Crosslinking agent)

For example, the acrylic adhesive composition may contain a crosslinking agent. Use of the crosslinking agent can bring about crosslinking of the acrylic polymer, to thereby give the adhesive layer durability as a certain level of hardness.

Examples of the crosslinking agent may include a crosslinking agent which is capable of forming a chemical crosslink, such as an isocyanate-based crosslinking agent, an epoxy-based crosslinking agent, an aziridine-based crosslinking agent, a melamine-based crosslinking agent, an aldehyde-based crosslinking agent, an amine-based crosslinking agent, and a metal chelate-based crosslinking agent; and a crosslinking agent which is capable of forming a physical crosslink, such as a multifunctional acrylate-based crosslinking agent. Among these, a crosslinking agent which is capable of reacting with a hydroxyl group is preferable, and an isocyanate-based crosslinking agent and a metal chelate-based crosslinking agent are more preferable. Furthermore, in terms of the improvement of the adhesion between the substrate and the adhesive layer, and the reactivity with the acrylic polymer, an isocyanate-based crosslinking agent is particularly preferable.

Examples of the isocyanate-based crosslinking agent may include 2,4-tolylene diisocyanate, 2,6-tolylene diisocyanate, hydrogenated tolylene diisocyanate, 1,3-xylene diisocyanate, 1,4-xylylene diisocyanate, hexamethylene diisocyanate, diphenylmethane-4,4-diisocyanate, isophorone diisocyanate, 1,3-bis(isocyanatomethyl)cyclohexane, tetramethylxylylene diisocyanate, 1,5-naphthalene diisocyanate, and triphenylmethane triisocyanate; adducts of these polyisocyanate compounds and a polyol compound such as trimethylol propane; biurets of these polyisocyanate compounds; and isocyanurates of these polyisocyanate compounds.

Examples of the metal chelate-based crosslinking agent may include acetyl acetone or acetoacetyl ester coordination compounds of multivalent metal, such as aluminum, iron, copper, zinc, tin, titanium, nickel, antimony, magnesium, vanadium, chromium, and zirconium.

As the crosslinking agent, one type thereof may be solely used, and two or more types thereof may also be used at any ratio.

The amount of the crosslinking agent is preferably 0.01 parts by weight or more, more preferably 0.02 parts by weight or more, and particularly preferably 0.03 parts by weight or more, and is preferably 20 parts by weight or less, more preferably 15 parts by weight or less, and particularly preferably 10 parts by weight or less, relative to 100 parts by weight of the acrylic polymer. When the amount of the crosslinking agent is equal to or more than the lower limit value of the aforementioned range, cohesion strength can be increased so that the durability of the adhesive layer is effectively enhanced. When it is equal to or less than the upper limit value, the adhesive layer is likely to have favorable flexibility and adhesiveness.

(Plasticizer)

For example, the acrylic adhesive composition may contain a plasticizer. Use of the plasticizer can reduce the viscosity of the acrylic adhesive composition, so that the adhesive layer can maintain favorable adhesiveness. Usually, when the acrylic adhesive composition contains the aforementioned inorganic oxide particles, viscosity is increased. As a result, adhesiveness tends to be reduced. In contrast to this, when the acrylic adhesive composition contains a plasticizer in combination with the inorganic oxide particles, the adhesive layer can retain favorable adhesiveness. Therefore, high refractive index and high adhesiveness can be balanced.

The melting point of the plasticizer is preferably -70°C or higher, and more preferably -60°C or higher, and is preferably 0°C or lower, and more preferably -10°C or lower. When the melting point of the plasticizer falls within this range, compatibility among the components contained in the acrylic adhesive composition can become favorable. Further, the adhesiveness of the adhesion layer can be confined within an appropriate range while adhesive residues are suppressed. As described herein, adhesive residues refer to a phenomenon in which the acrylic adhesive composition remains on an optional member when the optical layered body is peeled from the optional member after the optical layered body is bonded to the optional member.

Examples of the plasticizer may include a polybutene, vinyl ethers, a polyether (including a polyalkylene oxide and a functionalized polyalkylene oxide), esters, a polyol (for example, glycerin), a petroleum resin, a hydrogenated petroleum resin, and a styrene-based compound (for example, $\alpha$-methylstyrene). Among these, esters are preferable, because they have favorable miscibility with the acrylic polymer and relatively high refractive index. In particular, an aromatic ring-containing ester, such as benzoic acid-based and phthalic acid-based esters is preferable.

Examples of the benzoic acid ester which may be used as the plasticizer may include diethylene glycol dibenzoate, dipropylene glycol dibenzoate, benzyl benzoate, and 1,4-cyclohexanedimethanol dibenzoate. Particularly preferable examples of the benzoic acid ester-based plasticizer may include dipropylene glycol dibenzoate and benzyl benzoate. Examples of the phthalic acid ester may include dimethyl phthalate, diethyl phthalate, dibutyl phthalate, butyl benzyl phthalate, dicyclohexyl phthalate, and ethyl phthalyl ethyl glycolate. Examples of a commercially available plasticizer may include trade name "BENZOFLEX 9-88SG" (manufactured by Eastman Chemical Company) and trade name "$\alpha$-methylstyrene" (manufactured by Mitsubishi Chemical Corporation).

As the plasticizer, one type thereof may be solely used, and two or more types thereof may also be used at any ratio.

The amount of the plasticizer is preferably 5 parts by weight or more, and more preferably 10 parts by weight or more, and is preferably 20 parts by weight or less, and more preferably 15 parts by weight or less, relative to 100 parts by weight of the acrylic polymer.

(Silane Coupling Agent)

For example, the acrylic adhesive composition may contain a silane coupling agent. Examples of the silane coupling agent may include vinyltrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, 3-ureidopropyltriethoxysilane, 3-mercaptopropylmethyldimethoxysilane, 3-mercaptopropyltrimethoxysilane, bis(triethoxysilylpropyl)tetrasulfide, and 3-isocyanatopropyltriethoxysilane. Examples of a commercially available silane coupling agent may include trade name "KBM-803" (manufactured by Shin-Etsu Chemical Co., Ltd.).

As the silane coupling agent, one type thereof may be solely used, and two or more types thereof may also be used at any ratio.

The amount of the silane coupling agent is preferably 0.05 parts by weight or more, and more preferably 0.1 parts by weight or more, and is preferably 5 parts by weight or less, and more preferably 3 parts by weight or less, relative to 100 parts by weight of the acrylic polymer.

(Other Additives)

The acrylic adhesive composition may contain an additive other than the aforementioned components. Examples of such an additive may include an antistatic agent; an adhesive agent other than the aforementioned adhesive agents; an adhesion-imparting agent, such as a urethane resin, rosin, a rosin ester, a hydrogenated rosin ester, a phenolic resin, an aromatic-modified terpene resin, an aliphatic petroleum resin, an alicyclic petroleum resin, a styrene-based resin, and a xylene-based resin; a colorant; a filler; an aging resistor; an ultraviolet ray absorber; a functional pigment; and a compound which can be colored or discolored by irradiation with ultraviolet light or radiation. Furthermore, other than the aforementioned additives, a small amount of a component such as impurities contained in a raw material for producing the constituent components of the acrylic adhesive composition may be contained in the acrylic adhesive composition. The amounts of these components may be adequately set such that desired properties can be obtained.

[3.1.3. Properties of Acrylic Adhesive Composition]

The refractive index of the acrylic adhesive composition is usually 1.52 or more, preferably 1.53 or more, and more preferably 1.54 or more, and is usually 1.67 or less, preferably 1.66 or less, more preferably 1.65 or less, and particularly preferably 1.64 or less. When the refractive index of the acrylic adhesive composition is equal to or more than the lower limit value of the aforementioned range, light extraction efficiency can be effectively improved when the optical layered body is provided to an organic EL element. Furthermore, since light extraction efficiency can be improved even when the amount of the light scattering particles is not large, adhesiveness of the adhesive layer can be enhanced. When the refractive index of the acrylic adhesive composition is equal to or less than the upper limit value of the aforementioned range, the amount of the inorganic oxide particles can be reduced, and thereby the adhesive layer can be made flexible.

The refractive index may be measured using an ellipsometer ("M-2000" manufactured by J. A. Woollam Japan Co., Inc.).

Since the acrylic adhesive composition has adhesiveness, the composition is capable of acting as an adhesive agent. As described herein, the "adhesive agent" refers to a material having a shear storage modulus at 23°C of less than 1 MPa and exhibiting adhesiveness at normal temperature. Such an adhesive agent is a pressure sensitive adhesive agent that can express adhesiveness as a result of pressure application, and thus can achieve bonding without incurring effects such as deterioration caused by heating on a member to be bonded with the optical layered body.

[3.2. Light scattering particles]

The light scattering particles are particles which can scatter light. With this light scattering particles, scattering of light passing through the adhesive layer can be achieved. Therefore, light extraction efficiency can be improved when the optical layered body according to the present invention is provided to an organic EL element.

As the light scattering particles, there are used particles having a specific refractive index which is lower than that of the acrylic adhesive composition. Specifically, the refractive index of the light scattering particles is usually 1.4 or more, preferably 1.41 or more, and more preferably 1.42 or more, and is usually 1.49 or less, preferably 1.48 or less, and more preferably 1.47 or less. When the refractive index of the light scattering particles falls within the aforementioned range, light can be effectively reflected at the interface between the light scattering particles and the acrylic adhesive composition. Accordingly, light can be sufficiently scattered in the adhesive layer.

As the material of the light scattering particles, an inorganic material may be used, and an organic material may also be used. Among these, an organic material is preferably used as a material of the light scattering particles. The adhesive layer is usually produced with a coating liquid suitable for producing the adhesive layer. In this coating liquid, the light scattering particles are likely to settle down. In particular, the light scattering particles made of an inorganic material having a heavy specific gravity are likely to settle down. In contrast to this, the light scattering particles made of an organic material are unlikely to settle down. Therefore, dispersibility of the light scattering particles in the adhesive layer can be enhanced. When the dispersibility of the light scattering particles is favorable in this manner, characteristics, such as adhesiveness are likely to be stably expressed in the adhesive layer.

Preferable examples of the organic material which may be used as a material of the light scattering particles may include a resin, such as a silicone resin, an acrylic resin, and a polystyrene resin. Among these, a silicone resin and an acrylic resin are preferable, because they can be easily dispersed, and sedimentation is unlikely to be caused after dispersion. Therefore, silicone particles made of a silicone resin or acryl particles made of an acrylic resin are preferably used as the light scattering particles.

Examples of the light scattering particles may include, as the light scattering particles made of a silicone resin, trade name "XC-99" (manufactured by Momentive Performance Materials Inc., volume-average particle diameter: 0.7 $\mu$m). Examples of the light scattering particles made of an acrylic resin may include trade name "MP series" (manufactured by Soken Chemical & Engineering Co., Ltd., volume-average particle diameter 0.8 $\mu$m). Furthermore, examples of the light scattering particles made of a polystyrene resin may include trade name "SX series" (manufactured by Soken Chemical & Engineering Co., Ltd., volume-average particle diameter: 3.5 $\mu$m).

As the light scattering particles, one type thereof may be solely used, and two or more types thereof may also be used at any ratio.

The volume-average particle diameter of the light scattering particles is preferably 0.1 $\mu$m or more, more preferably 0.3 $\mu$m or more, and particularly preferably 0.4 $\mu$m or more, and is preferably 1 $\mu$m or less, and more preferably 0.9 $\mu$m or less. When the volume-average particle diameter of the light scattering particles is equal to or more than the lower limit value of the aforementioned range, the particle diameter of the light scattering particles can be stably made larger than the wavelength of the light to be scattered. Accordingly, visible light can be stably scattered by the light scattering particles. When the volume-average particle diameter of the light scattering particles is equal to or less than the upper limit value, the particle diameter can be reduced. Accordingly, the light having impinged the light scattering particles can be reflected in a wide range, and thereby efficient scattering of visible light can be achieved.

Furthermore, it is preferable that the particle diameter of at least 1/4 in volume of the light scattering particles contained in the adhesive layer falls within the range of 0.1 $\mu$m to 1 $\mu$m. More specifically, preferably 25% by volume or more, more preferably 35% by volume or more, and particularly preferably 50% by volume or more of the light scattering particles contained in the adhesive layer preferably has a particle diameter of 0.1 $\mu$m to 1 $\mu$m. Since the light scattering particles having a particle diameter of 0.1 $\mu$m to 1 $\mu$m has a large surface area, light can be effectively scattered. Therefore, light extraction efficiency can be effectively improved when the optical layered body according to the present invention is provided to an organic EL element. When the adhesive layer contains a large amount of the light scattering particles having a particle diameter of 1 $\mu$m or more, haze of the adhesive layer can be increased. Accordingly, observation of the opposite side through the adhesive layer can be hindered. Therefore, visual recognition of a wiring and a reflective electrode of an organic EL element can be hindered when the optical layered body according to the present invention is provided to an organic EL element. Accordingly, aesthetic appearances can be improved.

The volume concentration V of the light scattering particles relative to the adhesive layer, relative to the total volume of the adhesive layer being 100%, is usually 3% or more, preferably 4% or more, and more preferably 5% or more, and is usually 35% or less, preferably 30% or less, and more preferably 25% or less. When the volume concentration V of the light scattering particles is equal to or more than the lower limit value of the aforementioned range, scattering of light can be increased. When it is equal to or less than the upper limit value of the aforementioned range, the acrylic polymer and the light scattering particles can have favorable compatibility, and thereby dispersibility of the light scattering particles can be improved. Therefore, when the volume concentration V of the light scattering particles falls within the aforementioned range, light extraction efficiency can be effectively improved when the optical layered body according to the present invention is provided to an organic EL element.

[3.3. Attribute and Size of Adhesive Layer]

When the thickness of the adhesive layer is "D1", and the mean free path of light scattering in the adhesive layer is "L1", the ratio "D1/L1" is preferably 1 or more, more preferably 1.2 or more, and particularly preferably 1.4 or more, and is preferably 6 or less, more preferably 5.5 or less, and particularly preferably 5 or less. The aforementioned ratio D1/L1 indicates how many times in average the light passing through the adhesive layer is reflected on the surface of the light scattering particles. When the ratio D1/L1 falls within the aforementioned range, light extraction efficiency can be effectively improved when the optical layered body according to the present invention is provided to an organic EL element.

In general, the mean free path L1 of light scattering in the adhesive layer containing the adhesive composition and the light scattering particles dispersed in the adhesive composition is calculated by "mean free path L1 = 1/(number density of light scattering particles × scattering cross section)".

The number density of the light scattering particles is the number of light scattering particles per unit volume. The number density of the light scattering particles is usually calculated using the value of a volume per one light scattering particle. When calculating the value of a volume per one light scattering particle, the particle diameter of the light scattering particle is used in some cases. In general, since there is a distribution for the particle diameter of the light scattering particles, the volume-average particle diameter of the light scattering particles is used as a representative value, as the particle diameter to be used for the calculation of the number density of the light scattering particles. For the simplification of the calculation of the value of a volume per one light scattering particle, the shape of the light scattering particle may be assumed to be spherical for the sake of calculation.

The scattering cross-sectional area may be calculated by the Mie scattering theory (Mie theory). The Mie scattering theory is to calculate the solution to the Maxwell's equation for a case in which, in a medium (matrix) having a uniform refractive index, there exist spherical particles having a refractive index different from that of the medium. The spherical particles corresponds to the light scattering particles, and the medium corresponds to the adhesive composition. According to this theory, the aforementioned scattering cross-sectional area is calculated by "scattering cross-sectional area = scattering efficiency K($\alpha$) × actual cross-sectional area $\pi r^2$ of spherical particle".

The strength distribution I($\alpha$,$\theta$) which is dependent on the angle of scattered light is represented by the following formula (2). Scattering efficiency K($\alpha$) is represented by the following formula (3). Furthermore, $\alpha$ is represented by the following formula (4), and is a quantity equivalent to a radius r of the spherical particles which is normalized by a wavelength $\lambda$ of the light in the medium. The angle $\theta$ is a scattering angle, and the direction identical to the proceeding direction of incident light is set to be $\theta$ = 180°. $i_1$ and $i_2$ in the formula (2) are represented by the formula (5). Furthermore, a and b with a subscript v in the formulae (3) to (5) are represented by the formula (6). P(cos $\theta$) with a superscript 1 and a subscript v is constituted by the Legendre polynomials. a and b with a subscript v are constituted of linear and quadratic Recatti-Bessel functions $\Psi_v$ and $\zeta_v$ (provided that $_v$ indicates the subscript v) and derivatives thereof. m is a relative refractive index of the spherical particles based on the matrix, and m = $n_{scatter}$/$n_{matrix}$. $n_{scatter}$ indicates the refractive index of the spherical particles. $n_{matrix}$ indicates the refractive index of the medium.

$$I(\alpha,\theta) = \frac{\lambda^2}{8\pi^2}(i_1 + i_2) \tag{2}$$

$$K(\alpha) = \left(\frac{2}{\alpha^2}\right)\sum_{v=1}^{\infty}(2v+1)\left(|a_v|^2 + |b_v^2|\right) \tag{3}$$

$$\alpha = 2\pi r / \lambda \tag{4}$$

$$i_1 = \left|\sum_{v=1}^{\infty}\frac{2v+1}{v(v+1)}\left\{a_v \frac{P_v^1(\cos\theta)}{\sin\theta} + b_v \frac{dP_v^1(\cos\theta)}{d\theta}\right\}\right|^2 \tag{5}$$

$$i_2 = \left|\sum_{v=1}^{\infty}\frac{2v+1}{v(v+1)}\left\{b_v \frac{P_v^1(\cos\theta)}{\sin\theta} + a_v \frac{dP_v^1(\cos\theta)}{d\theta}\right\}\right|^2$$

$$a_v = \frac{\Psi_v'(m\alpha)\Psi_v(\alpha) - m\Psi_v(m\alpha)\Psi_v'(\alpha)}{\Psi_v'(m\alpha)\zeta_v(\alpha) - m\Psi_v(m\alpha)\zeta_v'(\alpha)}$$

$$(6)$$

$$b_v = \frac{m\Psi_v'(m\alpha)\Psi_v(\alpha) - \Psi_v(m\alpha)\Psi_v'(\alpha)}{m\Psi_v'(m\alpha)\zeta_v(\alpha) - \Psi_v(m\alpha)\zeta_v'(\alpha)}$$

For example, FIG. 2 illustrates the mean free path L1 in the adhesive layer containing an adhesive composition with a refractive index of 1.56 and silicone particles with a refractive index of 1.43 as the light scattering particles in an amount of approximately 10.6% by weight (8% by volume), which is calculated for light having a wavelength of 550 nm in a vacuum by the aforementioned method. In the example illustrated in FIG. 2, there is illustrated the mean free path L1 when the particle diameter of the light scattering particles is changed to 200 nm, 600 nm, 1000 nm, 1500 nm and 2000 nm while the volume concentration V of the light scattering particles in the adhesive layer is maintained constant. In the calculation, the number density [number of particles/mm$^3$] of the light scattering particles was calculated on the assumption that the specific gravity of the adhesive composition is 1 g/cm$^3$, and the specific gravity of the light scattering particles is 1.32 g/cm$^3$. Furthermore, the shape of the light scattering particles was assumed to be spherical. Such an assumption that the shape of the light scattering particles is spherical is applicable when the shape of the actual light scattering particles is approximately spherical. Furthermore, even when the shape of the actual light scattering particles is not approximately spherical, it is considered that a similar tendency would be exhibited because the tendency of the mean free path L1 and the particle diameter of the light scattering particle is a matter of size.

The thickness D1 of the adhesive layer is preferably 3 $\mu$m or more, more preferably 5 $\mu$m or more, and particularly preferably 10 $\mu$m or more, and is preferably 500 $\mu$m or less, more preferably 300 $\mu$m or less, and particularly preferably 250 $\mu$m or less. When the thickness D1 of the adhesive layer is equal to or more than the lower limit value of the aforementioned range, light can be sufficiently scattered by the adhesive layer. When the thickness D1 of the adhesive layer is equal to or less than the upper limit value of the aforementioned range, the surface of the adhesive layer can be easily flattened.

The total light transmittance of the adhesive layer is preferably 80% or more, and more preferably 85% or more. The total light transmittance may be measured in accordance with JIS K 7136.

The intimate contact property of the adhesive layer to glass are preferably 5 N/25 mm or more, and more preferably 7.5 N/25 mm or more. When the intimate contact property of the adhesive layer to glass is high in this manner, the optical layered body can strongly adhere to an organic EL element. The upper limit of the intimate contact property of the adhesive layer to glass is usually, but not particularly limited to, 30 N/25 mm or less. The intimate contact property of the adhesive layer to glass may be measured in accordance with JIS K 6854-1.

[3.4. Method for Producing Adhesive Layer]

As the method for producing the adhesive layer, there may be adopted any method by which a desired adhesive layer may be obtained. Usually, the adhesive layer is produced by a production method which includes a step of forming a film of a coating liquid containing the acrylic polymer and the light scattering particles, and a step of curing the film of the coating liquid to obtain the adhesive layer.

The aforementioned coating liquid is a coating liquid for forming the adhesive layer, and contains the components to be contained in the adhesive layer. Therefore, the adhesive layer may contain the acrylic polymer and the light scattering particles, and as necessary, the optional component such as inorganic oxide particles, a crosslinking agent, a plasticizer, and a silane coupling agent. Furthermore, the coating liquid may contain a solvent.

As the solvent, there may be used a solvent in which the acrylic polymer can dissolve. Examples of the solvent may include an ester-based solvent, such as methyl acetate, ethyl acetate, methyl acetoacetate, and ethyl acetoacetate; a ketone-based solvent, such as acetone, methyl ethyl ketone, and methyl isobutyl ketone; an aromatic-based solvent, such as toluene and xylene; and an alcohol-based solvent, such as methanol, ethanol, and propyl alcohol. Among these, ethyl acetate and methyl ethyl ketone are preferable in terms of solubility, drying properties, and prices. As the solvent, one type thereof may be solely used, and two or more types thereof may also be used at any ratio.

It is noted that the components contained in the adhesive layer (that is, components such as the acrylic polymer, the light scattering particles, and the optional component) may be prepared as a solution or a suspension in some cases. For example, the aforementioned components are sometimes prepared as a solution or a suspension containing the aforementioned components when the aforementioned components are produced by a production method using a solvent, as well as when a commercially available product is purchased as the aforementioned components. In such a case, the aforementioned solution or suspension as it is may be added in order to prepare a coating liquid for forming the adhesive layer. In this case, the solvent contained in the solution or suspension may be used as a portion or all of the solvent of the coating liquid for forming the adhesive layer.

The amount of the solvent is usually set such that the solid content concentration of the coating liquid may be adjusted to a desired concentration. The solid content concentration of the coating liquid is preferably 5% by weight or more, more preferably 10% by weight or more, and particularly preferably 20% by weight or more, and is preferably 90% by weight or less, more preferably 80% by weight or less, and particularly preferably 75% by weight or less. The solid content of a certain liquid refers to a substance which remains after drying of the liquid.

The viscosity of the coating liquid at 25°C is preferably 20,000 mPa·s or less, more preferably 18,000 mPa·s or less, and particularly preferably 15,000 mPa·s or less, and is preferably 100 mPa·s or more. When the viscosity of the coating liquid is made low to such level, occurrence of coating streaks can be suppressed. Accordingly, formation of a uniform film of a coating liquid is facilitated. The viscosity may be measured in accordance with "9. Methods for viscosity measurement by single cylindrical rotational viscometer" of JIS Z8803 (2011).

After the coating liquid has been prepared, the step of forming a film of the coating liquid is performed. Usually, a film of the coating liquid is formed by applying the coating liquid onto an appropriate support surface. Examples of the coating method to be used may include roll coating, die coating, gravure coating, comma coating, and screen printing. In the optical layered body according to the present invention, the compatibility between the acrylic polymer and particles in the adhesive layer is favorable, and the amount of particles can be reduced. Therefore, the coating liquid can be easily applied in a uniform manner. Accordingly, occurrence of defects (local projections or indentations) can be suppressed.

After the film of the coating liquid has been formed, the step of curing this film of the coating liquid to obtain the adhesive layer is performed. Usually, the adhesive layer is obtained by drying the film of the adhesive layer thereby to cure the film of the coating liquid. Drying is usually performed by heat drying. Specific drying conditions may be optionally set within the range that allows a desired adhesive layer to be obtained. The drying temperature is preferably 50°C or higher, more preferably 60°C or higher, further preferably 65°C or higher, and particularly preferably 70°C or higher, and is preferably 250°C or lower, more preferably 150°C or lower, further preferably 120°C or lower, and particularly preferably 95°C or lower. The drying time is preferably 10 seconds to 10 minutes.

The method for producing the adhesive layer may further include an optional step in combination with the aforementioned steps.

For example, when a crosslinking agent is used, it is preferable to perform an aging treatment step after the adhesive layer has been obtained by curing the film of the coating liquid. By performing this aging treatment step, the adhesive properties of the adhesive layer can be balanced. The temperature condition of the aging treatment is usually room temperature to 70°C. The treatment time of the aging treatment is usually 1 day to 30 days. Specifically, for example, the treatment may be performed under conditions such as 1 day to 20 days at 23°C, 3 days to 10 days at 23°C, and 1 day to 7 days at 40°C. In the present invention, a layer which has not been subjected to the aging treatment yet and a layer obtained after the aging treatment are both referred to as the "adhesive layer".

[4. Optional Layer]

The optical layered body according to the present invention may further include an optional layer in combination with the substrate and the adhesive layer.

For example, a peelable separator film layer may be provided on the adhesive layer on the side opposite to the substrate. The provision of such a separator film layer can protect the adhesive layer, and facilitate the winding up of the optical layered body.

For example, a light diffusing layer may be provided on the substrate on the side opposite to the adhesive layer. The light diffusing layer is a layer which contains a material having light diffusing properties. The provision of the light diffusing layer can diffuse light passing through the light diffusing layer, to thereby change the path of light. Accordingly, the light path length can be increased, and light extraction efficiency can further be enhanced.

Furthermore, for example, an ultraviolet absorbing layer may be provided on the substrate on the side opposite to the adhesive layer. This can suppress the deterioration, due to ultraviolet rays, of the substrate and the adhesive layer as well as an organic material contained in an organic EL element to which the optical layered body is bonded.

[5. Use Application and Others of Optical Layered Body]

The adhesive layer of the optical layered body according to the present invention has high adhesiveness. Therefore, the optical layered body can adhere to an optional member by bonding the surface of the adhesive layer to the optional member. In the optical layered body according to the present invention, the adhesive layer can scatter light passing through the adhesive layer. Therefore, when the optical layered body according to the present invention is disposed on one side of an organic EL element, the light extraction efficiency of the light generated in a light-emitting layer in the organic EL element can be increased. Therefore, the optical layered body according to the present invention is suitably used in the use application of producing a light source device in combination with an organic EL element.

Since the adhesive layer includes the light scattering particles which can scatter light, the optical layered body according to the present invention has haze. The specific haze of the optical layered body may be appropriately set according to the use application of the optical layered body. Specifically, the haze of the optical layered body is preferably 20% or more, more preferably 40% or more, and particularly preferably 70% or more, and is preferably 99% or less, more preferably 97% or less, and particularly preferably 95% or less. When such a haze is provided, visual recognition of a wiring and a reflective electrode of an organic EL element can be hindered when the optical layered body is provided to the organic EL element. Accordingly, aesthetic appearances can be improved.

[6. Method for Producing Optical Layered Body]

The method for producing the optical layered body may be any method as long as a desired optical layered body is obtained.

For example, the optical layered body may be produced by producing the adhesive layer by the aforementioned method using the surface of the substrate as a support surface. In this case, the optical layered body may be produced by a first production method which includes a step of forming on the substrate a film of a coating liquid for forming the adhesive layer, and a step of curing this film of the coating liquid to obtain the adhesive layer.

Alternatively, for example, the optical layered body may be produced by, after having produced the adhesive layer in the aforementioned method, bonding the produced adhesive layer to the substrate. In this case, the optical layered body may be produced by a second production method which includes a step of forming a film of a coating liquid for forming the adhesive layer, a step of curing this film of the coating liquid to obtain the adhesive layer, and a step of bonding this adhesive layer to the substrate.

In particular, when there is a possibility that the substrate may be deteriorated in the steps for producing the adhesive layer, due to factors, such as a solvent contained in the coating liquid, heat for drying the film of the coating liquid, and irradiation with active energy rays, the optical layered body is preferably produced by the second production method. Specific examples of such a second production method may include: applying a coating liquid onto a surface coated with silicone or the like to have release properties, of a separator film layer; drying the coating liquid to obtain an adhesive layer; and bonding this adhesive layer to the substrate to obtain the optical layered body. Such a method can be performed as long as the aforementioned adhesive layer is employed, even when the smoothness of the surface of the substrate to be bonded to the adhesive layer is low, for example, when the substrate has been subjected to an embossing treatment.

[7. Light source device]

A light source device may be obtained by disposing the optical layered body according to the present invention to one side of an organic EL element. Usually, a light source device is produced by bonding the surface of the optical layered body on the adhesive layer side to a light output surface of an organic EL element.

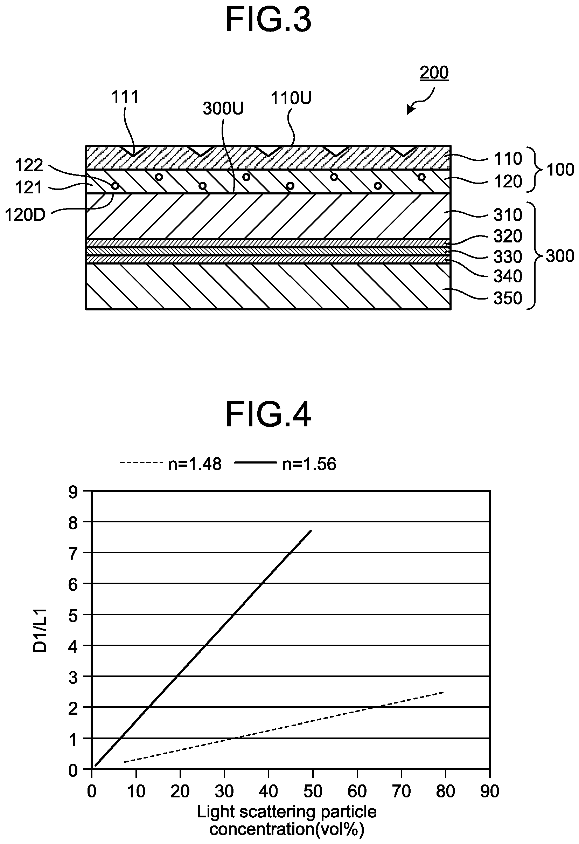

FIG. 3 is a cross-sectional view schematically illustrating a cross section of an example of a light source device including an optical layered body according to an embodiment of the present invention cut along a flat plane parallel to a thickness direction thereof.

As illustrated in FIG. 3, a light source device 200 includes an organic EL element 300 and an optical layered body 100.

The organic EL element 300 includes a substrate layer 310, a transparent electrode layer 320, a light-emitting layer 330, an electrode layer 340, and a sealing layer 350 in this order. Light may be generated in the light-emitting layer 330 when voltage is applied from the transparent electrode layer 320 and the electrode layer 340.

Usually, such an organic EL element 300 may be produced by sequentially forming layers such as the transparent electrode layer 320, the light-emitting layer 330, and the electrode layer 340 on the substrate layer 310 by a layer formation method such as sputtering, and sealing these layers by the sealing layer 350. As such a substrate layer 310, a glass plate is often used. The refractive index of this glass plate tends to be higher than that of a general resin.

The surface 120D of the adhesive layer 120 opposite to the substrate 110 of the optical layered body 100 is bonded to a light output surface 300U of the organic EL element 300. Therefore, light which is generated in the light-emitting layer 330 passes through the transparent electrode layer 320, the substrate layer 310, the adhesive layer 120, and the substrate 110 in this order, and exits through the surface 110U. The adhesive layer 120 according to the present embodiment contains the light scattering particles 122. Accordingly, light can be scattered in the adhesive layer 120. Therefore, according to the light source device 200 illustrated in the present embodiment, extraction of light through the optical layered body 100 can be efficiently performed.

If the refractive index of the adhesive composition contained in the adhesive layer 120 is low, the refractive index difference between the substrate layer 310 and the adhesive layer 120 becomes large. Accordingly, there is a possibility that light may be reflected at the interface between the substrate layer 310 and the adhesive layer 120, causing light extraction efficiency to be decreased. However, since the acrylic adhesive composition contained in the adhesive layer 120 according to the present embodiment has a high refractive index, the refractive index difference between the substrate layer 310 and the adhesive layer 120 can be reduced. Therefore, reflection at the interface between the substrate layer 310 and the adhesive layer 120 is suppressed. Accordingly, in the light source device 200 according to the present embodiment, light extraction efficiency is further increased.

The aforementioned light source device may be used for use applications such as a lighting apparatus and a backlight device. The lighting apparatus includes the aforementioned light source device as a light source, and may further include an optional component, such as a member for holding the light source and a circuit for supplying electric power. The backlight device includes the aforementioned light source device as a light source, and may further include an optional component, such as a casing, a circuit for supplying electric power, a diffusion plate for obtaining further uniform exiting light, a diffusion sheet, and a prism sheet. The backlight device may be used as a backlight of a display device that controls pixels to display an image, such as a liquid crystal display device, and as a backlight of a display device that displays a fixed image such as a signboard.

[Examples]

Hereinafter, the present invention will be specifically described by illustrating Examples. However, the present invention is not limited to Examples described below. The present invention may be freely modified and practiced without departing from the scope of claims of the present invention and the scope of their equivalents.

In the following Examples and Comparative Examples, "%" and "part" indicating the amount of a material are on the basis of weight, unless otherwise stated. Operations in Examples and Comparative Examples were performed under the environment of normal temperature and normal pressure, unless otherwise stated.

Furthermore, in the following Examples and Comparative Examples, the mean free path of light scattering in the adhesive layer was calculated for light having a wavelength of 550 nm in a vacuum by the aforementioned method using the Mie scattering theory.

[Example 1]

(Production of Acrylic Polymer (A-1))

A mixture (X) in which 0.16 parts of azobisisobutyronitrile (AIBN) as a polymerization initiator is dissolved in 70 parts of benzyl acrylate (a1), 15 parts of 2-hydroxyethyl acrylate (a2) and 15 parts of butyl acrylate (a3) was prepared.

Into a reaction container equipped with a thermometer, a stirrer, a dropping funnel, and a reflux condenser, 28 parts of methyl ethyl ketone and 8 parts of toluene were charged, and the temperature was raised while stirring. After the temperature in the reaction container reached 90°C, the aforementioned mixture (X) was dropped into the reaction container for 2 hours. Furthermore, polymerization was performed for 7 hours while sequentially adding, in the reaction container, a polymerization catalyst liquid in which 0.06 parts of AIBN were dissolved in 2 parts of ethyl acetate, during the polymerization. Thus, a solution of an acrylic polymer (A-1) (solid content concentration 65.1%, viscosity 1300 mPa·s (25°C)) was obtained. The acrylic polymer (A-1) had a weight-average molecular weight of 105,000, a number-average molecular weight of 36,000, a molecular weight distribution of 2.92, and a glass transition temperature of -8.3°C.

(Measurement of Refractive Index of Adhesive Composition)

100 parts, in terms of the solid content, of the solution of the acrylic polymer (A-1) and 0.3 parts of a 55% ethyl acetate solution of a tolylene diisocyanate adduct of trimethylol propane ("CORONATE L-55E" manufactured by Nippon Polyurethane Industry Co., Ltd.) were mixed to produce a coating liquid. This coating liquid was applied onto one surface of a polyester-based release sheet such that the thickness after drying becomes 30 μm, and dried at 100°C for 4 minutes. Thus, an adhesive layer for analysis was formed. Another polyester-based release sheet was bonded on the surface of the adhesive layer for analysis opposite to the release sheet. The bonded product was subjected to aging under the condition of 40°C for 10 days. Thus, a layered body for analysis, which includes the release sheet, the adhesive layer, and the release sheet in this order, was obtained. This layered body for analysis was used to measure the refractive index of the adhesive layer for analysis. As a result, the refractive index was 1.54.

(Production of Optical Layered Body)

The aforementioned solution of the acrylic polymer (A-1) was sampled in an amount equivalent to 100 parts by weight of the solid content. To the solution of the acrylic polymer (A-1) sampled in this manner, 6 parts by weight of light scattering particles ("XC-99" manufactured by Momentive Performance Materials Inc., silicone particles having a volume-average particle diameter adjusted to 0.7 μm, refractive index 1.43) was added. Then, the mixture was stirred for 15 minutes. To this solution, 0.3 parts of a 55% ethyl acetate solution of a tolylene diisocyanate adduct of trimethylol propane ("CORONATE L-55E" manufactured by Nippon Polyurethane Industry Co., Ltd.) were further added. Then, the mixture was stirred for 15 minutes to obtain a coating liquid for forming an adhesive layer. This coating liquid was applied onto one surface of a polyethylene terephthalate film as a substrate ("U34" manufactured by Toray Industries, Inc., thickness 100 μm) such that the thickness after drying becomes 60 μm, and dried at 80°C for 5 minutes. Thus, an adhesive layer was formed. Thereafter, a polyester-based release sheet was bonded on the surface of the adhesive layer opposite to the substrate. The bonded product was subjected to aging under the condition of 80°C for 14 days. Accordingly, an optical layered body which includes the release sheet, the adhesive layer, and the substrate in this order was obtained. When calculated in consideration of specific gravity, the volume concentration V of the light scattering particles in the adhesive layer was 5%.

The surface of the optical layered body obtained in this manner on the release sheet side was observed to check the defects of the adhesive layer. At the portion where defects were formed in the adhesive layer, indentations or projections on the surface of the release sheet are locally formed. When the number of indentations or projections observed was small (when the number of defects per 1 m² was less than 100), the layered body was evaluated as "good". When the number of indentations or projections was large (when the number of defects per 1 m² was 100 or more), the layered body was evaluated as "failure".

Also, the value of D1/L1 of the adhesive layer was calculated by the Mie scattering theory (Mie theory). Also, the haze of the optical layered body was measured.

Furthermore, a commercially available organic EL element was prepared, and the total luminous flux of this organic EL element was measured.

Also, the release sheet was peeled from the aforementioned optical layered body, and the surface of the adhesive layer opposite to the substrate was bonded to the light output surface of the organic EL element. Thus, a light source device was obtained. Then, the total luminous flux of this light source device was measured.

The light extraction efficiency was calculated by dividing the total luminous flux of the light source device by the total luminous flux of the organic EL element which does not include the optical layered body. The light extraction efficiency calculated in this manner indicates the magnitude of the total luminous flux of the light source device when the total luminous flux of the organic EL element which does not include the optical layered body is "1.00".

[Examples 2 to 6, Comparative Example 1 and Comparative Example 2]

The thickness of the adhesive layer and the volume concentration V of the light scattering particles were changed as indicated in Table 1. Except for this matter, an optical layered body was produced and evaluated in the same manner as in Example 1.

[Results of Examples 1 to 6, Comparative Example 1 and Comparative Example 2]

The results of Examples 1 to 6, Comparative Example 1, and Comparative Example 2 are shown in Table 1 illustrated below.

[Table 1. Results of Examples 1-6, and Comparative Examples 1,2]

| | Refractive index of adhesive composition | Thickness of adhesive layer (μm) | Refractive index of particles | Volume concentration of particles V (%) | Defects of adhesive layer | D1/L1 | Haze (%) | Light extraction efficiency |
|---|---|---|---|---|---|---|---|---|
| Ex. 1 | 1.54 | 60 | 1.43 | 5 | Good | 2.0 | 69 | 1.42 |
| Ex. 2 | 1.54 | 20 | 1.43 | 15 | Good | 2.0 | 73 | 1.44 |
| Ex. 3 | 1.54 | 20 | 1.43 | 20 | Good | 2.7 | 83 | 1.48 |
| Ex. 4 | 1.54 | 20 | 1.43 | 30 | Good | 4.1 | 92 | 1.48 |
| Ex. 5 | 1.54 | 40 | 1.43 | 10 | Good | 2.7 | 83 | 1.48 |
| Ex. 6 | 1.54 | 10 | 1.43 | 30 | Good | 2.0 | 40 | 1.46 |

(continued)

| | Refracti ve index of adhesive composit ion | Thickn ess of adhesi ve layer ($\mu$m) | Refracti ve index of particle s | Volume concen tratio n of partic les V (% ) | Defect s of adhesi ve layer | D1/L1 | Haz e (%) | Light extrac tion effici ency |
|---|---|---|---|---|---|---|---|---|
| Com p. Ex. 1 | 1.54 | 20 | 1.43 | 1 | Good | 0.14 | 7 | 1.15 |
| Com p. Ex. 2 | 1.54 | 25 | 1.43 | 40 | Poor | 6.8 | 95 | 1.40 |

[Example 7]

The solution of the acrylic polymer (A-1) was sampled in an amount of 100 parts by weight in terms of the solid content. To the solution of the acrylic polymer (A-1) sampled in this manner, there were added: 130 parts by weight of inorganic oxide particles ("NANON5 ZR-010" manufactured by Solar Co., Ltd., volume-average particle diameter 15 nm); 14 parts by weight of a plasticizer ("BENZOFLEX 9-88SG" manufactured by Eastman Chemical Company, melting point -30°C); and 26 parts by weight of light scattering particles ("XC-99" manufactured by Momentive Performance Materials Inc., silicone particles having a volume-average particle diameter adjusted to 0.7 $\mu$m, refractive index 1.43). Then, the mixture was stirred for 15 minutes to obtain a solution which contains the dispersed light scattering particles. The amount of the light scattering particles used here was calculated in consideration of specific gravity. As a result, the amount was such that the volume concentration V of the light scattering particles in a subsequently formed adhesive layer becomes 15%. To this solution, 0.3 parts of a 55% ethyl acetate solution of a tolylene diisocyanate adduct of trimethylol propane ("CORONATE L-55E" manufactured by Nippon Polyurethane Industry Co., Ltd.) were further added. Then, the mixture was stirred for 15 minutes to obtain a coating liquid.

The coating liquid produced in this manner was used as a coating liquid for forming an adhesive layer. Also, the thickness of the adhesive layer was changed to 20 $\mu$m. Except for these points, an optical layered body was produced and evaluated in the same manner as in Example 1. The results are shown in Table 2. Table 2 also shows the results of Example 2 for comparison.

[Table 2. Results of Examples 2 and 71

| | Refracti ve index of adhesive composit ion | Thickne ss of adhesiv e layer ($\mu$m) | Refractiv e index of particles | Volume concentra tion of particles V (%) | Defect s of adhesi ve layer | D1/L1 | Light extra ction effic iency |
|---|---|---|---|---|---|---|---|
| Ex. 2 | 1.54 | 20 | 1.43 | 15 | Good | 2.0 | 1.44 |
| Ex. 7 | 1.67 | 20 | 1.43 | 15 | Good | 7.7 | 1.48 |

[Example 8]

A mixture (Y) in which 0.16 parts of azobisisobutyronitrile (AIBN)) as a polymerization initiator is dissolved in 70 parts of phenoxy ethyl acrylate (a1), 15 parts of 2-hydroxyethyl acrylate (a2), and 15 parts of butyl acrylate (a3) was prepared.

Into a reaction container equipped with a thermometer, a stirrer, a dropping funnel, and a reflux condenser, 28 parts of methyl ethyl ketone and 8 parts of toluene were charged, and the temperature was raised while stirring. After the temperature in the reaction container reached 90°C, the aforementioned mixture (Y) was dropped into the reaction container for 2 hours. Furthermore, polymerization was performed for 7 hours while sequentially adding, in the reaction container, a polymerization catalyst liquid in which 0.06 parts of AIBN were dissolved in 2 parts of ethyl acetate, during the polymerization. Thus, a solution of an acrylic polymer (A-2) (solid content concentration 65.0%, viscosity 1100 mPa·s (25°C)) was obtained. The acrylic polymer (A-2) had a weight-average molecular weight of 108,000, a number-average molecular weight of 41,700, a molecular weight distribution of 2.59, and a glass transition temperature of -26.6°C.

In place of the solution of the acrylic polymer (A-1), the solution of the aforementioned acrylic polymer (A-2) was used. Also, the thickness of the adhesive layer was changed to 20 μm. Furthermore, the amount of the light scattering particles was changed such that the volume concentration V becomes 15%. Except for these points, an optical layered body was produced and evaluated in the same manner as in Example 1. The results are shown in Table 3. Table 3 also shows the results of Example 2 for comparison.

[Table 3. Results of Example 2 and Example 8]

|  | Refractive index of adhesive composition | Thickness of adhesive layer (μm) | Refractive index of particles | Volume concentration of particles V (%) | Defects of adhesive layer | D1/L1 | Light extraction efficiency |
|---|---|---|---|---|---|---|---|
| Ex. 2 | 1.54 | 20 | 1.43 | 15 | Good | 2.0 | 1.44 |
| Ex. 8 | 1.53 | 20 | 1.43 | 15 | Good | 1.7 | 1.42 |

[Example 9]

As the light scattering particles, there was used, in place of the use of only "XC-99" manufactured by Momentive Performance Materials Inc. (silicone particles having a volume-average particle diameter adjusted to 0.7 μm, refractive index 1.43), a combination of "XC-99" manufactured by Momentive Performance Materials Inc. (silicone particles having a volume-average particle diameter adjusted to 0.7 μm, refractive index 1.43) and "Tospearl 120" manufactured by Momentive Performance Materials Inc. (silicone particles having a volume-average particle diameter adjusted to 2 μm, refractive index 1.43). The amounts of these light scattering particles were adjusted such that the volume concentrations $V_1$ and $V_2$ of the light scattering particles in the adhesive layer to be produced become the values shown in Table 4 illustrated below. Here, $V_1$ indicates the volume concentration of the light scattering particles having a volume-average particle diameter of 0.7 μm, and $V_2$ indicates the volume concentration of the light scattering particles having a volume-average particle diameter of 2 μm.

Also, the thickness of the adhesive layer was changed to 20 μm.

Except for this point, an optical layered body was produced and evaluated in the same manner as in Example 1. The results are shown in Table 4. Table 4 also shows the results of Examples 3 and 4 for comparison. In Table 4, "Particle (0.7 μm)" indicates the light scattering particles having a volume-average particle diameter of 0.7 μm. Also, in Table 4, "Particle (2 μm)" indicates the light scattering particles having a volume-average particle diameter of 2 μm. As understood from Table 4, when at least 1/4 in volume of particles have a particle diameter of 0.1 μm to 1 μm, the volume concentration V of a small amount of the light scattering particles can improve both light extraction efficiency and haze. Therefore, there can be obtained the effect of concealing a reflective electrode of an organic EL element.

[Table 4. Results of Examples 3, 4 and 9]

|  | Refractive index of adhesive composition | Thickness of adhesive layer (μm) | Refractive index of particles | Volume concentration of particles (0.7 μm) $V_1$ | Volume concentration of particles (2 μm) $V_2$ (%) | D1/L1 | Haze | Light extraction efficiency |
|---|---|---|---|---|---|---|---|---|
| Ex. 3 | 1.54 | 20 | 1.43 | 20 | 0 | 2.7 | 83 | 1.48 |
| Ex. 4 | 1.54 | 20 | 1.43 | 30 | 0 | 4.1 | 92 | 1.48 |
| Ex. 9 | 1.54 | 20 | 1.43 | 20 | 4.5 | 4.1 | 92 | 1.48 |

[Examples 10 to 12 and Comparative Example 3]

The amount of the inorganic oxide particles ("NANON5 ZR-010" manufactured by Solar Co., Ltd., volume-average particle diameter 15 nm) relative to 100 parts by weight, in terms of the solid content, of the acrylic polymer (A-1) was changed to 23 parts by weight.

Also, the thickness of the adhesive layer and the volume concentration V of the light scattering particles were changed as shown in Table 5 illustrated below.

Except for these matters, an optical layered body was produced and evaluated in the same manner as in Example 7. The results are shown in Table 5.

[Table 5. Results of Examples 10-12 and Comparative Example 31

| | Refractive index of adhesive composition | Thickness of adhesive layer ($\mu$m) | Refract ive index of particl es | Volume concentrat ion of particles V (%) | D1/L1 | Haz e (%) | Light extra ction effic iency |
|---|---|---|---|---|---|---|---|
| Ex. 10 | 1.56 | 40 | 1.43 | 10 | 2.9 | 85 | 1.48 |
| Ex. 11 | 1.56 | 40 | 1.43 | 20 | 5.8 | 96 | 1.47 |
| Ex. 12 | 1.56 | 40 | 1.43 | 6 | 1.7 | 48 | 1.42 |
| Comp. Ex. 3 | 1.56 | 40 | 1.43 | 2 | 0.6 | 83 | 1.3 |

[Examples 13 to 15]

A coating liquid for forming an adhesive layer, which is the same as that in Example 10 was prepared. This coating liquid was applied onto one surface of a polyethylene terephthalate release sheet such that the thickness after drying becomes 40 $\mu$m, and dried at 80°C for 5 minutes. Thus, an adhesive layer was formed.

Also, a polyethylene terephthalate film (thickness 38 $\mu$m) was prepared. One surface of this film was subjected to a heat embossing treatment, thereby to form dot-like indentations having a maximum height (depth) Ry shown in Table 6, at a pitch of approximately 1 mm. Thus, a substrate was obtained.

The surface of the adhesive layer opposite to the release sheet was bonded to the surface of the substrate opposite to the surface on which the indentations were formed. The bonded product was subjected to aging under the condition of 80°C for 14 days. Thus, an optical layered body which includes the release sheet, the adhesive layer, and the substrate in this order was obtained.

The optical layered body obtained in this manner was evaluated in the same manner as in Example 1. Also, the surface of the optical layered body on the substrate side was observed to evaluate mat properties. When gloss is suppressed, the layered body was evaluated as "good". When gloss is viewed, the layered body was evaluated as "failure". The results are shown in Table 6. Table 6 also shows the results of Example 10 for comparison.

[Table 6. Results of Examples 10 and 13-151

| | Refractiv e index of adhesive compositi on | Thickn ess of adhesi ve layer ($\mu$m) | Refrac tive index of partic les | Ry ($\mu$m) | Ry/D2 | D1/L1 | Mat proper ties | Light extra ction effic iency |
|---|---|---|---|---|---|---|---|---|
| Ex. 10 | 1.56 | 40 | 1.43 | 0 | 0 | 2.9 | Poor | 1.48 |
| Ex. 13 | 1.56 | 40 | 1.43 | 2.2 | 0.06 | 2.9 | Good | 1.49 |
| Ex. 14 | 1.56 | 40 | 1.43 | 4.2 | 0.11 | 2.9 | Good | 1.48 |
| Ex. 15 | 1.56 | 40 | 1.43 | 8.5 | 0.23 | 2.9 | Good | 1.45 |

[Reference Example 1]

The ratio D1/L1 between the thickness D1 of the adhesive layer containing the light scattering particles and the adhesive composition and the mean free path L1 of light scattering, when the refractive index n of the adhesive composition used is 1.48 or 1.56, is illustrated in FIG. 4. In these instances, the layer thickness was 20 $\mu$m; the average particle diameter of the light scattering particles was 0.7 $\mu$m; and the refractive index of the light scattering particles was 1.43.

As understood from FIG. 4, when the adhesive composition used has a higher refractive index, a larger value of D1/L1 can be obtained with a smaller amount of the light scattering particles. Therefore, it is understood that the use of the adhesive composition having a high refractive index can facilitate achievement of a desired D1/L1. As a result, light extraction efficiency can be easily improved.

[Reference Sign List]

| 100: | optical layered body |
|---|---|
| 110: | substrate |
| 111: | recess |
| 120: | adhesive layer |
| 121: | acrylic adhesive composition |
| 122: | light scattering particles |
| 200: | light source device |
| 300: | organic EL element |
| 310: | substrate layer |
| 320: | transparent electrode layer |
| 330: | light-emitting layer |
| 340: | electrode layer |
| 350: | sealing layer |

**Claims**

1. An optical layered body comprising a substrate and an adhesive layer formed on the substrate, wherein
the adhesive layer includes an acrylic adhesive composition containing an acrylic polymer, and a light scattering particle,
the acrylic polymer is a copolymer of a copolymerizing component [I] which contains 40% by weight to 93% by weight of an aromatic ring-containing monomer (a1), and 7% by weight to 60% by weight of a hydroxyl group-containing monomer (a2),
the acrylic polymer has a weight-average molecular weight of 200,000 or less,
the light scattering particle has a volume concentration V relative to the adhesive layer of 3% to 35%,
the acrylic adhesive composition has a refractive index of 1.52 to 1.67, and
the light scattering particle has a refractive index of 1.4 to 1.49.

2. The optical layered body according to claim 1, wherein the light scattering particle is a silicone particle or an acryl particle.

3. The optical layered body according to claim 1 or 2, wherein at least 1/4 in volume of the light scattering particle contained in the adhesive layer has a particle diameter of 0.1 $\mu$m to 1 $\mu$m.

4. The optical layered body according to any one of claims 1 to 3, wherein
the light scattering particle has an average particle diameter of 0.1 $\mu$m to 1 $\mu$m, and
D1/L1 is 1 to 6, wherein D1 is a thickness of the adhesive layer, and L1 is a mean free path of light scattering.

5. The optical layered body according to any one of claims 1 to 4, wherein a surface of the substrate opposite to the adhesive layer has a concavo-convex structure.

6. The optical layered body according to claim 5, wherein
the substrate has a single-layer structure, and
0.05 < Ry/D2 < 0.25 is satisfied wherein Ry is a maximum height of the concavo-convex structure, and D2 is a thickness of the substrate.

7. The optical layered body according to any one of claims 1 to 6, which is to be disposed on one side of an organic electroluminescence element.

8.  A method for producing an optical layered body including a substrate and an adhesive layer, the method comprising the steps of:

    forming, on the substrate, a film of a coating liquid containing an acrylic polymer and a light scattering particle; and
    curing the film of the coating liquid to obtain the adhesive layer, wherein
    the acrylic polymer is a copolymer of a copolymerizing component [I] which contains 40% by weight to 93% by weight of an aromatic ring-containing monomer (a1), and 7% by weight to 60% by weight of a hydroxyl group-containing monomer (a2),
    the acrylic polymer has a weight-average molecular weight of 200,000 or less,
    the light scattering particle has a volume concentration V relative to the adhesive layer of 3% to 35%,
    the light scattering particle has a refractive index of 1.4 to 1.49, and
    an acrylic adhesive composition as a component other than the light scattering particle in the adhesive layer has a refractive index of 1.52 to 1.67.

9.  A method for producing an optical layered body including a substrate and an adhesive layer, the method comprising the steps of:

    forming a film of a coating liquid containing an acrylic polymer and a light scattering particle;
    curing the film of the coating liquid to obtain the adhesive layer; and
    bonding the adhesive layer and the substrate, wherein
    the acrylic polymer is a copolymer of a copolymerizing component [I] which contains 40% by weight to 93% by weight of an aromatic ring-containing monomer (a1), and 7% by weight to 60% by weight of a hydroxyl group-containing monomer (a2),
    the acrylic polymer has a weight-average molecular weight of 200,000 or less,
    the light scattering particle has a volume concentration V relative to the adhesive layer of 3% to 35%,
    the light scattering particle has a refractive index of 1.4 to 1.49, and
    an acrylic adhesive composition as a component other than the light scattering particle in the adhesive layer has a refractive index of 1.52 to 1.67.

# FIG.1

# FIG.2

# FIG.3

# FIG.4

## INTERNATIONAL SEARCH REPORT

| International application No. |
| --- |
| PCT/JP2016/053251 |

**A. CLASSIFICATION OF SUBJECT MATTER**

*G02B5/02*(2006.01)i, *B32B27/00*(2006.01)i, *B32B27/20*(2006.01)i, *C09J7/00*
(2006.01)i, *C09J133/00*(2006.01)i, *H01L51/50*(2006.01)i, *H05B33/02*
(2006.01)i

According to International Patent Classification (IPC) or to both national classification and IPC

**B. FIELDS SEARCHED**

Minimum documentation searched (classification system followed by classification symbols)
G02B5/02, B32B27/00, B32B27/20, C09J7/00, C09J133/00, H01L51/50,
H05B33/02

Documentation searched other than minimum documentation to the extent that such documents are included in the fields searched
Jitsuyo Shinan Koho        1922–1996   Jitsuyo Shinan Toroku Koho   1996–2016
Kokai Jitsuyo Shinan Koho   1971–2016   Toroku Jitsuyo Shinan Koho   1994–2016

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2012-128097 A  (Nippon Zeon Co., Ltd.), 05 July 2012 (05.07.2012), entire text; all drawings (Family: none) | 1-9 |
| A | JP 2014-209439 A  (Nippon Zeon Co., Ltd.), 06 November 2014 (06.11.2014), entire text; all drawings & US 2015/0349296 A1    & WO 2014/115639 A1 & EP 2949720 A1        & CN 104968752 A & KR 10-2015-0109376 A | 1-9 |
| A | JP 2008-310267 A  (Daio Paper Corp.), 25 December 2008 (25.12.2008), entire text; all drawings (Family: none) | 1-9 |

| [×]  Further documents are listed in the continuation of Box C. | [ ]  See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 26 April 2016 (26.04.16) | 17 May 2016 (17.05.16) |

| Name and mailing address of the ISA/ | Authorized officer |
| --- | --- |
| Japan Patent Office 3-4-3,Kasumigaseki,Chiyoda-ku, Tokyo 100-8915,Japan | Telephone No. |

Form PCT/ISA/210 (second sheet) (January 2015)

**INTERNATIONAL SEARCH REPORT**

| International application No. |
|---|
| PCT/JP2016/053251 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2014-224964 A (Nitto Denko Corp.),<br>04 December 2014 (04.12.2014),<br>entire text; all drawings<br>& JP 2014-224963 A        & US 2015/0226999 A1<br>& WO 2014/042110 A1      & TW 201416406 A<br>& KR 10-2015-0046094 A   & CN 104620143 A<br>& CN 104620142 A         & KR 10-2015-0054831 A<br>& TW 201415096 A | 1-9 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012002260 A